# EUROPEAN PATENT APPLICATION

(11) **EP 4 579 725 A2**
(43) Date of publication of application: **02.07.2025**
(21) Application number: 24211613.5
(22) Date of filing: 08.11.2024
(51) Int. Cl.: H01L 21/768, H10D 84/01

(54) **SELF-ALIGNED BACK-SIDE GATE VIAS**

(30) Priority: 29.12.2023 US 202318400710
(71) Applicant: INTEL Corporation, Santa Clara, CA 95054 (US)
(72) Inventor: KOBRINSKY, Mauro, Portland, 97229 (US); D'SILVA, Joseph, Hillsboro, 97124 (US); MILLS, Shaun, Hillsboro, 97123 (US); MANNEBACH, Ehren, Beaverton, 97007 (US)
(74) Representative: HGF

(57) **Abstract**

Transistor structures between and coupled to front- and back-side interconnect layers may have precisely aligned arrays of contacts and dielectric structures over and under the transistor structures. Back-side dielectric plugs may electrically isolate source and drain regions contacted on the front side from back-side interconnect lines. Back-side dielectric plugs may have a seam indicating plug formation from the back side, and the seam may be on a side contacting a back-side interconnect line. Spacer layers may insulate back-side gate contacts from adjacent back-side contacts. Contacts and dielectric structures on a back side may be formed using directed self-assembly of sacrificial materials aligned to sacrificial structures on source and drain regions and revealed on a substrate back side.

## Description

### BACKGROUND

Formation of back-side contacts and/or gate vias is limited, sometimes severely, by edge placement errors between back-side patterns and front-side features. Typical patterning misalignments may be dwarfed by wafer distortions, at least along certain orientations. Such misalignments may significantly degrade integrated circuit (IC) device performance or prevent further down-scaling of transistor arrays.

New techniques, structures, and materials are needed to improve front- and back-side feature alignments.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIG. 1 is a flow chart of methods for forming an array of back-side contacts and dielectric structures aligned with source and drain regions by intervening sacrificial structures, in accordance with some embodiments;
FIGS. 2, 3, 4, 5, 6, 7, 8, 9, 10, 11, 12, and 13 illustrate cross-sectional profile views of transistor structures between and coupled to front- and back-side interconnect layers, at various stages of manufacture, in accordance with some embodiments;
FIGS. 14A and 14B illustrate cross-sectional profile views of transistor structures between and coupled to front- and back-side interconnect layers and networks, in accordance with some embodiments;
FIG. 15 illustrates a cross-sectional profile view of an integrated circuit (IC) system having transistor structures with front- and back-side contacts and vias to front- and back-side interconnect layers, in accordance with some embodiments;
FIG. 16 illustrates a diagram of an example data server machine employing an IC device having self-aligned front- and back-side contacts and dielectric layers, in accordance with some embodiments; and
FIG. 17 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed to improve the alignment and scaling of integrated circuit (IC) devices having transistors between and coupled to front- and back-side interconnect networks.

Typical patterning methods may be insufficiently precise to properly align front- and back-side features in IC devices, particularly given the nonstop scaling down of devices. A method is described to form back-side arrays of sacrificial materials precisely aligned to transistor structures formed on a front side. Directed self-assembly (DSA) may be used to form an array or grating of dielectric or mask structures on a back side aligned to an array of features on a front side. DSA may first form sacrificial rows aligned to sacrificial structures on and under transistor structures coupled to front-side interconnects and revealed on the back side. The DSA, sacrificial rows may then enable subsequent self-aligned back-side contacts and vias. Self-alignment may be needed only in a single, key dimension (e.g., parallel to a longitudinal direction of a channel region).

Such self-aligned features enable back-side interconnects with continued device scaling. In addition to near-perfect alignment between front- and back-side features (e.g., front- and back-side contacts and dielectrics), described structures may include dielectric plugs with tell-tale seams formed on the back-side.

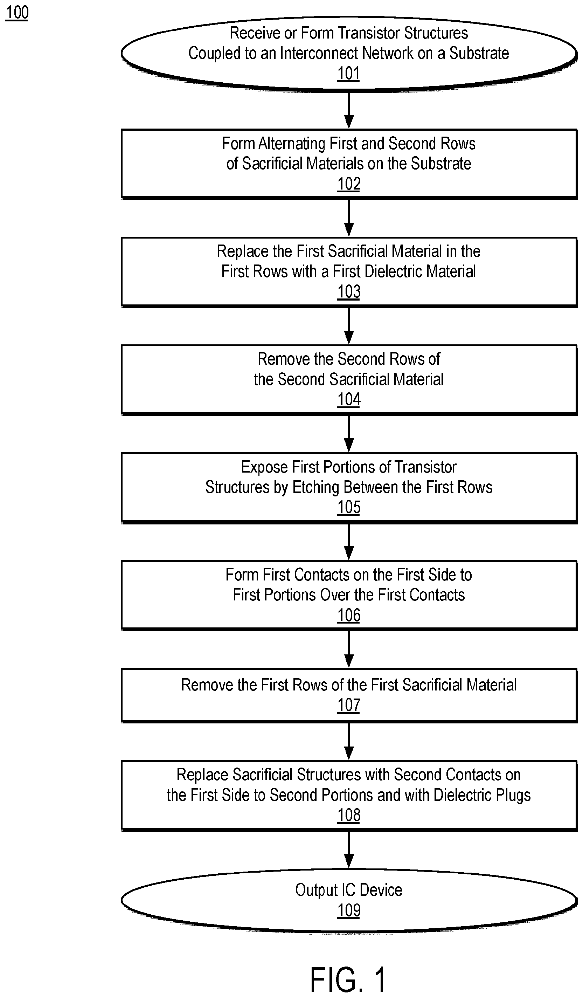

FIG. 1 is a flow chart of methods 100 for forming an array of back-side contacts and dielectric structures aligned with source and drain regions by intervening sacrificial structures, in accordance with some embodiments. Methods 100 include operations 101-109. Some operations shown in FIG. 1 are optional. Additional operations may be included. FIG. 1 shows an example sequence, but the operations can be done in other orders as well, and some operations may be omitted. Some operations can also be performed multiple times before other operations are performed. Some operations may be included within other operations so that the number of operations illustrated FIG. 1 is not a limitation of the methods 100.

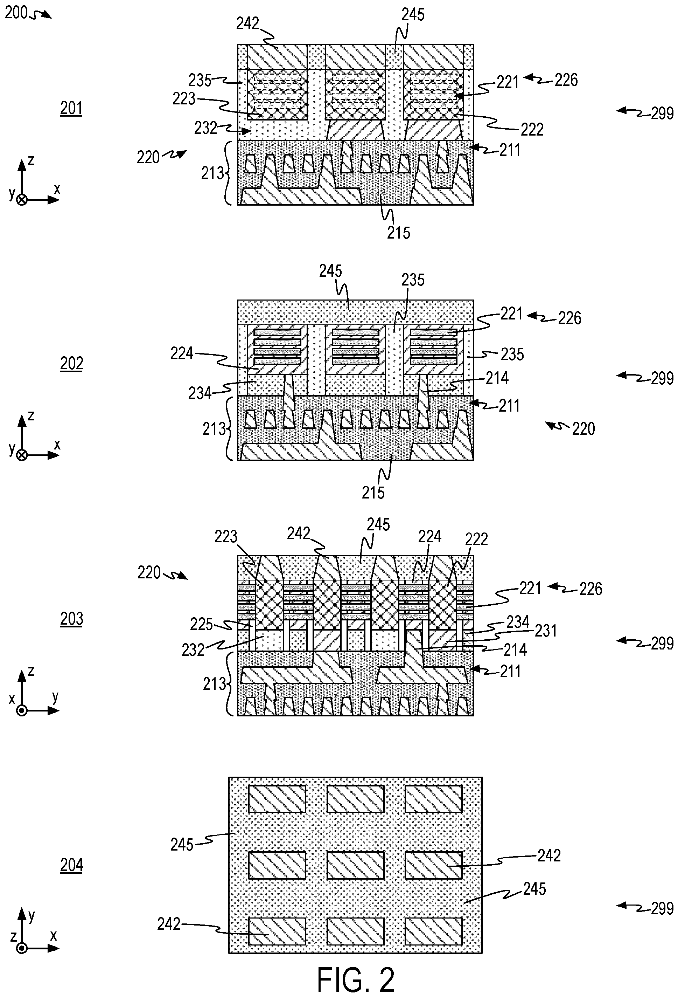

FIGS. 2, 3, 4, 5, 6, 7, 8, 9, 10, 11, 12, and 13 illustrate cross-sectional profile views of transistor structures between and coupled to front- and back-side interconnect layers, at various stages of manufacture, in accordance with some embodiments. FIGS. 2-13 show possible examples of intermediate structures during an embodiment of a practice of methods 100 of FIG. 1.

Returning to FIG. 1, methods 100 begin at operation 101 with receiving a substrate. In some embodiments, the substrate has multiple transistor structures (e.g., in extensive arrays), and the multiple transistor structures are coupled to an interconnect network (e.g., on a front side) over the transistor structures. The transistor structures each include channel regions between source and drain regions and gate electrodes over the channel regions and between the source and drain regions, for example, in field-effect transistor (FET) structures. The channels regions may be in any suitable structures, such as nanoribbons, fins, etc. Nanoribbons may be in a stack of mechanically and electrically parallel nanoribbons between the source and drain regions. Nanoribbons of both conductivity types (e.g., in complementary FETs (CFETs) or forksheet FETs) may be grouped together in one or more stacks. Nanoribbons may be of any suitable width or length. Some nanoribbons may have dimensions fitting nanowires or nanosheets.

Notably, the substrate may be received with an array of sacrificial structures under an array of transistor structures coupled to an already-formed (e.g., a front-side) interconnect layer and network. The sacrificial structures may already be revealed on a side (e.g., a back-side) opposite the interconnect network. In other embodiments, the sacrificial structures are revealed after receipt of the substrate on a side of the substrate opposite the metallization network. The revealing may be by any suitable means. An interconnect network may be on the top or front side of the substrate, and the sacrificial and transistor structures coupled to the interconnect network may be covered by a significant thickness of crystalline (e.g., semiconductor) material on the back side of the substrate. In many embodiments, the substrate is coupled (e.g., bonded) to a carrier substrate and inverted (e.g., flipped over), and the substrate is recessed down to the sacrificial structures on the back side of the substrate. In some such embodiments, the substrate is a wafer, and the carrier substrate is a carrier wafer. In some embodiments, at least some of the recessing is by grinding. In some such embodiments, after grinding, the revealing of the sacrificial structures is by polishing (or planarizing, e.g., chemical-mechanical polishing (CMP)). Such a polishing operation may be through crystalline and dielectric materials and endpoint on the material (e.g., metal) of the sacrificial structures once revealed.

In some embodiments, the sacrificial and transistor structures are formed after receiving the substrate. In some such embodiments, the sacrificial structures are formed under the transistor structures (e.g., on a front-side, before the transistor structures are formed) by opening an array of holes in the substrate (e.g., at every fin cut between channel regions). The holes may be etched (or otherwise formed) by any suitable means, and a sacrificial material may then be deposited into the holes. Semiconductor regions (e.g., source and drain regions of semiconductor material) may then be formed over the sacrificial structures. At least some of the sacrificial structures may later be replaced by (e.g., back-side) contacts to the source and drain regions, but a dense and regular array of sacrificial structures may be formed (e.g., at every fin cut between channel regions, whether or not a back-side contact is to be formed there) to provide a superior template for subsequent self-alignment (e.g., DSA). After formation of sacrificial, transistor, and interconnect structures, the sacrificial structures may be revealed as previously described.

In many embodiments, the sacrificial material is a metallic material, such as any of those described below for use in the interconnect network (e.g., metallization layers). In some such embodiments, the sacrificial material includes titanium and nitrogen. In some embodiments, the sacrificial material includes tungsten. Other materials (such as dielectric or semiconductor materials) may be deployed. The employment of a sacrificial material (rather than a component material of the transistor structures, for example) advantageously allows for depth control (e.g., endpointing) of a back-side recess without modification or disruption of the transistor structures. The employment of a sacrificial metal may beneficially provide a good etch selectivity to multiple dielectrics to be retained on the substrate when eventually removing the sacrificial material.

The interconnect network may be or include one or more metallization layers. As used herein, the term "metallization layer" describes layers with interconnections or wires that provide electrical routing, generally formed of metal or other electrically conductive material. Adjacent metallization layers may be formed of different materials and by different methods. Adjacent metallization layers are interconnected by vias that may be characterized as part of the metallization layers or between the metallization layers. In some embodiments, front-side metallization layers are formed over and immediately adjacent transistor structures. Front-side metallization layers may include M0 (metal 0), V0 (via 0), M1, M2/V1, M3/V2, M4/V3, and M4-M12, or any number of metallization layers such as eight or more metallization layers. Metallization layers are embedded within dielectric materials, for example, with interconnected metal lines and vias extending through dielectric material.

Metallization layers may be formed by any suitable means and may include any suitable materials. In many embodiments, metallization layers are in interconnect structures having one or more of copper (Cu), tungsten (W), ruthenium (Ru), molybdenum (Mo), gold (Au), tantalum (Ta), cobalt (Co), aluminum (Al), and nickel (Ni), including in alloys. Metallization layers may include any of these or other metals. In some embodiments, metallization layers include nitrides of metals, e.g., tantalum and titanium (Ti). Metallization layers may include other electrically conductive materials, including non-metals. Metallization layers may be built up in a back-end-of-line (BEOL) process. Although metallization layers may be built up in a BEOL process in some exemplary embodiments, other means of forming metallization layers may be utilized.

The substrate may include any suitable material or materials. Any suitable semiconductor or other material can be used. The substrate may be any suitable substrate, such as a wafer, die, etc. The substrate may include a semiconductor material that transistors can be formed out of and on, including a crystalline material, such as monocrystalline or polycrystalline silicon (Si), germanium (Ge), silicon germanium (SiGe), a III-V alloy material (e.g., gallium arsenide (GaAs)), a silicon carbide (SiC), a sapphire (Al₂O₃), or any combination thereof. In some embodiments, the substrate includes crystalline silicon and subsequent components are also silicon. The substrate may be a silicon-on-insulator (SOI) substrate. One or more fins, nanoribbons, etc., of semiconductor material may be included in or on the substrate. The fin or fins may be of the same material as the substrate or formed, e.g., deposited, on the substrate. The substrate may also include semiconductor materials, metals, dielectrics, dopants, and other materials commonly found in IC substrates. In many embodiments, the received substrate includes metallization layers in an interconnect structure on one side (e.g., a front side), coupled to transistor structures, and a thickness of crystalline material (such as a semiconductor material) under the transistor structures (e.g., on a back side).

FIG. 2 illustrates transistor structures 220 coupled to a first metallization layer 211 in a workpiece or IC device 200 and revealed sacrificial structures 240 on a back side of substrate 299, in accordance with some embodiments, for example, following a performance of receiving operation 101. Device 200 includes transistor structures 220 having channel regions 226 in stacks of nanoribbons 221. Channel regions 226 are between and coupling drain and source regions 222, 223. A gate electrode 224 is adjacent nanoribbons 221. Some features of this and other figures are simplified. Some materials and structures (such as various liner layers, gate dielectric layers, contact metals, etc.) are not shown. Any illustrated layouts or routing are for example only and do not necessarily correspond to actual circuit layouts.

FIG. 2 shows cross-sectional profile views 201, 202, 203, as well as plan view 204 of the back side of substrate 299 (but facing up, the positive z-direction), of IC device 200. Notably, device 200 and substrate 299 may be inverted relative to typical or original orientations of some previous processing. Views 201, 202 have x-z viewing planes with view 201 in source or drain regions 222, 223 (between gate electrodes 224) and view 202 in gate electrodes 224 (between drain and source regions 222, 223). View 202 shows a transverse profile cut of channel regions 226 with nanoribbons 221 extending through gate electrode 224 in the y-direction. The viewing plane of view 201 is between ends of collinear nanoribbons 221, but the outlines of nanoribbons 221 (e.g., just behind the viewing plane) are shown with dashed lines (e.g., for illustrative purposes). View 203 shows a longitudinal profile cut of channel regions 226 with nanoribbons 221 extending in the y-directions between drain and source regions 222, 223.

Metallization layer 211 is coupled to transistor structures 220. For example, metallization layer 211 is coupled to some of drain and source regions 222, 223. Some of drain and source regions 222, 223 are not coupled to layer 211, but will be coupled to an interconnect layer and network opposite layer 211, e.g., a back-side interconnect layer and network. Metallization layer 211 is part of an interconnect or metallization network 213 over transistor structures 220 (e.g., often, in some orientations), e.g., a front-side interconnect network 213. Metallization layers 211 and network 213 may be substantially as described at operation 101 of FIG. 1, e.g., including lines and vias of copper, tungsten, ruthenium, molybdenum, or other metals, and extending through dielectric materials 215. Material 215 may be any suitable (e.g., electrically insulating) material(s). In many embodiments, dielectric materials 215 includes silicon and oxygen (e.g., in an oxide of silicon, such as silicon dioxide, SiO₂). In some such embodiments, dielectric materials 215 also include nitrogen and/or carbon. Materials 215 may include distinct portions with differing compositions. In some embodiments, a bulk dielectric material 215 provides isolation between conductors in interconnect layers 211, and one or more liner dielectric materials 215 provide interfaces (e.g., between bulk material(s) 215 and conductors, between layers of bulk material(s) 215, such as etch stops, etc.).

Transistor structures 220 may be FETs having channel regions 226 of any suitable structure coupling drain and source regions 222, 223, as shown in view 203. In some embodiments, as shown in FIG. 2, channel regions 226 include stacks of nanoribbons 221. In other embodiments, channel regions 226 include single nanoribbons 221 or stacks of nanoribbons 221 having more or fewer nanoribbons 221 (i.e., an arbitrary number of nanoribbons 221) than in the exemplary embodiment of FIG. 2. Although transistor structures 220 in FIG. 2 each have a stack of vertically aligned nanoribbons 221 with a same conductivity type (e.g., either n- or p-type conductivity), other embodiments deploy stacked transistor structures 220 with nanoribbons 221 of both conductivity types (e.g., in CFETs or forksheet FETs). In other embodiments, channel regions 226 may be in fins (e.g., in FinFETs) or any other suitable channel structure.

Channel regions 226 may be of any suitable material and composition for a channel of a transistor. In some examples, channel regions 226 are substantially silicon. In other embodiments, channel regions 226 include germanium (e.g., Si_{1-X}Ge_{X}, Ge_{1-X}Sn_{X}, or substantially pure Ge). In some embodiments, channel regions 226 include a transition metal and a chalcogen. The transition metal may be any transition metal such as any element of groups 4 through 11, the group 3 elements scandium and yttrium, and the inner transition metals (e.g., f-block lanthanide and actinide series). Notable transition metals are molybdenum and tungsten. The chalcogen may be sulfur, selenium, or tellurium. In still other embodiments, channel region 226 includes one or more metals and oxygen (i.e., metal oxide semiconductor), such as, but not limited to, indium, gallium zinc oxide (IGZO).

Channel regions 226 are advantageously crystalline. Although the crystalline semiconductor includes polycrystalline thin film material, channel regions 226 may be substantially monocrystalline. In some embodiments where channel region 226 is substantially pure silicon, the crystallinity of channel region 226 is cubic with a top surface having crystallographic orientation of (100), (111), or (110), for example. Other crystallographic orientations are also possible. Channel regions 226 may also be polycrystalline or amorphous, for example in certain metal chalcogen and/or metal oxide embodiments.

As illustrated in views 202, 203, transistor structure 220 includes gate electrode 224 adjacent channel region 226 and between drain and source regions 222, 223 as part of a gate structure. The gate structure includes at least gate electrode 224 and a gate dielectric (not shown) over channel region 226. Gate electrode 224 may include one or more gate metals, such as a liner metal and a bulk metal enclose by the liner metal. A gate metal liner may include multiple layers of liner metal, and a bulk metal may also include multiple metals. Gate metal(s) may be chosen due to a metal workfunction, which may have an effect on a transistor voltage threshold V_{TH}. Gate electrode 224 may include any of the metals previously described, e.g., for metallization layers 211 (such as tantalum, titanium, tungsten, etc.), and/or other metals (e.g., for workfunction considerations).

A gate contact or via 214 may connect and couple gate electrode 224 to layer 211. Contacts or vias (not shown) may couple a given gate electrode 224 to front-side layer 211 but just in front of or behind the viewing plane of, e.g., view 203. Other gate electrodes 224 may be coupled to a metallization layer opposite metallization layer 211. Gate contact or via 214 may include any of the metals previously described, e.g., for metallization layers 211, such as tungsten, titanium, molybdenum, etc.

A gate structure includes a gate dielectric (not shown) between channel region 226 and a gate metal of gate electrode 224, e.g., to provide electrical insulation between channel region 226 and gate electrode 224 and to electrostatically control of transistor structure 220. For example, a gate dielectric between channel region 226 and gate electrode 224 might be shown as around nanoribbons 221 in view 202 and above and below nanoribbons 221 in view 203. A gate dielectric may have more than one layer and may be of any suitable material(s). The one or more layers of gate dielectric may include a silicon oxide (such as SiOz), a silicon oxynitride, etc. Advantageously, the gate dielectric includes a high-permittivity ("high-K") dielectric, which may improve transconductance. For example, a high-K dielectric may result in increased conductance of transistor structure 220 (through channel region 226) for a given gate bias.

A front-side gate isolation layer 234 is on (e.g., in contact with) gate electrode 224, as shown in views 202, 203. Gate layer 234 is an insulator structure over gate electrode 224, between gate electrode 224 and metallization layer 211. Gate layer 234 is advantageously a low-K dielectric structure or layer, e.g., to minimize capacitances between electrode 224 and adjacent conductors, such as metallization layers 211. Gate layer 234 may include silicon (for example, in an oxide, nitride, carbide, etc., of silicon). Gate layer 234 advantageously has an etch selectivity with adjacent dielectric structures, such as dielectric structure 235 adjacent and between transistor structures 220 (as shown in views 201, 202). In many embodiments, gate layer 234 includes silicon and nitrogen.

Drain and source regions 222, 223 are electrically and physically coupled to opposite ends of channel regions 226. Drain and source regions 222, 223 are impurity doped regions., e.g., regions of semiconductor material doped with one or more electrically active impurities and having increased charge-carrier availabilities and associated conductivities. Drain and source regions 222, 223 may be doped with an opposite type (e.g., n- or p-type) or of similar type to channel region 226. Drain and source regions 222, 223 may include a predominant semiconductor material, and one or more n-dopants (such as phosphorus, arsenic, or antimony) or p-type impurities (such as boron or aluminum). Other dopant materials may be used. Any suitable means of formation may be used. Regions 222, 223 may be epitaxially grown semiconductor regions, for example, of a Group IV semiconductor material (e.g., Si, Ge, SiGe, GeSn alloy). Other semiconductor materials may be employed. Regions 222, 223 are substantially crystalline. Drain and source regions 222, 223 may be polycrystalline or substantially monocrystalline, e.g., having long-range order at least adjacent ends of channel regions 226 and merging or joining into a unitary body with few grain boundaries.

In many embodiments, transistor structures 220 are physically symmetrical about channel regions 226 and gate electrode 224, and identifiers drain and source regions 222, 223 may be reversed interchangeably in many contexts. However, the classification of drain and source regions 222, 223 may be by the electrical relationships of transistor structure 220 and regions 222, 223 to other components in a given circuit (e.g., and the consequent direction of current flow through structure 220 and regions 222, 223). In some embodiments, at least some drain regions 222 are coupled to an upper metallization layer 211, and at least some source regions 223 are coupled to a lower metallization layer, opposite an upper metallization layer 211.

Drain and source regions 222, 223 may be separated from gate electrodes 224 by gate spacer layers 225 between gate electrode 224 and regions 222, 223. In many embodiments, gate spacer layers 225 are in contact with gate electrode 224 and regions 222, 223. Gate spacer layers 225 extend beyond the tops of gate electrode 224 and are in contact with gate layers 234, as shown in view 203. Gate spacer layers 225 are layers of insulator material, advantageously of low-K dielectric material, e.g., to minimize capacitances between electrode 224 and adjacent conductors, such as region 222, 223. Gate spacer layer 225 may include silicon (for example, in an oxide, nitride, carbide, etc., of silicon). Gate spacer layer 225 advantageously has an etch selectivity with adjacent dielectric structures, such as layer 234, dielectric structure 235, etc. In many embodiments, gate spacer layer 225 includes silicon, oxygen, carbon, and nitrogen.

Gate spacer layers 225 are also between gate layers 234 and dielectric structures 232, which are on drain and source regions 222, 223. Dielectric structures 232 may be similar to gate layers 234, but as front-side insulator structures 232 on regions 222, 223 rather than gate electrode 224. Insulator structures 232 are between drain and source regions 222, 223 and metallization layer 211. Structure 232 is advantageously a low-K dielectric structure or layer, e.g., to minimize capacitances between regions 222, 223 and adjacent conductors, such as metallization layers 211. Dielectric structure 232 may include silicon (for example, in an oxide, nitride, carbide, etc., of silicon). Dielectric structure 232 advantageously has an etch selectivity with adjacent dielectric structures, such as layers 225, 234. In some embodiments, insulator structures 232 have a same composition, and are continuous with, dielectric structure 235 adjacent and between transistor structures 220, as shown in view 201.

Dielectric structures 235 are between transistor structures 220, for example, between gate electrodes 224 and between drain and source regions 222, 223. Dielectric structures 235 isolate adjacent transistor structures 220 and advantageously include a low-K dielectric material. Dielectric structures 235 may include silicon (for example, in an oxide, nitride, carbide, etc., of silicon). In many embodiments, dielectric structures 235 include silicon and oxygen.

Some drain and source regions 222, 223 are coupled to metallization layer 211 by vias or contacts 231 on regions 222, 223. Drain and source regions 222, 223 not contacted by vias or contacts 231 may be coupled to a metallization layer opposite metallization layer 211. Contacts 231 are through dielectric structures 232 or in place of dielectric structures 232 on regions 222, 223. Contacts 231 are metal structures that couple transistor structure 220 to interconnect layers 211. In some embodiments, additional metallization structures (not shown) couple contacts 231 to layer 211. For example, drain and source contact vias may couple with contacts 231 and layer 211 in a plane behind or in front of the plane of view 203. In some embodiments, contacts 231 directly contact layer 211, e.g., much like via 214 couples gate electrode 224 to interconnect layer 211. In some embodiments, one or more additional metallization structures (not shown) are between contact 231 and layer 211, and the structure(s) couple contact 231 to layer 211. Drain and source contacts 231 may include any of the metals previously described, e.g., for metallization layers 211, such as tungsten, titanium, molybdenum, etc.

Substrate 299 maybe much as described of the substrate at operation 101 of FIG. 1, for example, including a crystalline material, as well as metals, dielectrics, dopants, and other materials commonly found in IC substrates. In the exemplary embodiment of FIG. 2, substrate 299 was built up from a substantially monocrystalline silicon base (e.g., under transistor structures 220 and metallization layer 211, etc.) to now include any subsequently added materials and structures, such as transistor structures 220, dielectrics and metals in layer 211, etc. The thickness of the crystalline base, e.g., previously on a backside of transistor structures 220, may have been much thicker (e.g., tens of microns) than the height or thickness of transistor structures 220 between the crystalline base and metallization layer 211.

Sacrificial structures 242 are on regions 222, 223, e.g., to the back side, opposite interconnect layer 211 and network 213. Structures 242 (and their dimensions) may control a back-side recess depth down to just over regions 222, 223 and may later be replaced, e.g., by a conductor to form back-side contacts to regions 222, 223 or by a dielectric to form an insulating plug between regions 222, 223 and a back-side interconnect network. Sacrificial structures 242 may be of any suitable material, e.g., as described at least at operation 101. In some embodiments, structures 242 include a metallic material, such as titanium or tungsten. In some embodiments, sacrificial structures 242 include silicon and one or more of oxygen, carbon, and nitrogen.

Isolation structure(s) 245 are between adjacent sacrificial structures 242 in both the x- and y-directions. Isolation structures 245 may have a composition similar to dielectric materials 215 or structures 235. Isolation structures 245 may include silicon (for example, in an oxide, nitride, carbide, etc., of silicon). In many embodiments, isolation structures 245 include silicon and oxygen. In some embodiments, isolation structures 245 include silicon and nitrogen.

Plan view 204 illustrates the back side of substrate 299 and shows the array of sacrificial structures 242 on drain and source regions 222, 223. Dielectric structure 245 extends in the x- and y-directions between sacrificial structures 242, over electrodes 224. The array of sacrificial structures 242 may advantageously be regular and densely populated to provide a satisfactory base or template for subsequent formation (e.g., by DSA) of sacrificial rows self-aligned to transistor structures 220 (via sacrificial structures 242).

Returning to FIG. 1, methods 100 continue at operation 102 by forming alternating first and second rows of first and second sacrificial materials on the substrate. In at least some embodiments, the first rows are formed in contact with the array of sacrificial structures on the semiconductor (e.g., drain and source) regions. Consequently, the array of sacrificial structures is between (and in contact with both of) the first rows of the first sacrificial material and the array of transistor structures coupled to the (e.g., front-side) interconnect network. In many embodiments, forming the alternating first and second rows includes directed self-assembly. In some embodiments, the first rows of the first sacrificial material are formed on the sacrificial structures by self-assembled monolayers (SAMs) of a first organic molecule, and the second rows of the second sacrificial material are formed by SAMs of a second organic molecule. The second rows are formed between the first rows. For example, two groups of SAMs may be deployed, the first with head groups having a strong affinity for the sacrificial material (e.g., a metal) of the sacrificial structures and the second with head groups having a strong affinity for the dielectric material (over the gate electrodes) and between the sacrificial structures) over the drain and source regions).

First and second block co-polymer (BCP) sacrificial materials may be deployed as tail or functional groups connected to the first and second groups, respectively, of SAMs. Example BCPs are polystyrene and polymethylmethacrylate, but any suitable sacrificial materials may be utilized. Pairs of BCPs may be chosen to have mutual etch selectivities. The directed self-assembly may form long-range ordered structures precisely aligned with either the sacrificial structures (e.g., the first rows of first sacrificial materials) or the dielectric material between the sacrificial structures (e.g., the second rows of second sacrificial materials). The deployment of a metallic material in the sacrificial structures may advantageously enable the selection of pairs of SAMs with differing affinities, the first SAM with an affinity for the sacrificial structures (e.g., a metal) and the second SAM with an affinity for the dielectric material between the sacrificial structures. The ordered structures of the first sacrificial material (e.g., the first SAM and BCP pair) bridge the dielectric material(s) separating sacrificial structures to form first rows of the first sacrificial material. The ordered structures of the second sacrificial material (e.g., the second SAM and BCP pair) align on the dielectric materials separating the sacrificial structures, between the first rows of the first sacrificial material, to form second rows of the second sacrificial material, alternating with the first rows of the first sacrificial material.

The self-alignment enabled by the organic monolayers obviates any need for patterning the sacrificial materials and is advantageously much more precise than photolithographic patterning. Misalignment of around 5 nm between structures over and under gate electrodes or drain and source regions can be expected just due to typical lithographic patterning. In many embodiments, the sacrificial materials (and subsequent replacement structures) self-assembled on a back side are substantially vertically aligned with front-side structures. Used herein, the term "substantially vertically aligned" denotes an alignment (e.g., of sidewalls) within 5 nm, i.e., having a misalignment of less than 5 nm. More precise alignments can be expected with directed self-assembly of monolayers on the gate electrode array. In some embodiments, the sacrificial materials (and subsequent replacement structures) self-assembled on a back side are precisely vertically aligned with front-side structures. Used herein, the term "precisely vertically aligned" denotes an alignment (e.g., of sidewalls) within 2 nm, i.e., having a misalignment of less than 2 nm. Otherwise, with patterning a back side, misalignments of around 15 or 20 nm can be expected in some dimensions due to wafer distortion (e.g., along certain axes relative to a crystallographic orientation).

The self-alignment enabled by the organic monolayers precisely aligns (e.g., nearly perfectly aligns) the sacrificial materials (and so subsequent replacement structures) with the respective gate electrodes or drain and source regions. The effectively-perfect alignment of back-side feature sidewalls or edges with front-side feature edges or sidewalls translates into back-side critical dimensions (CDs) being effective duplicates of the front-side CDs.

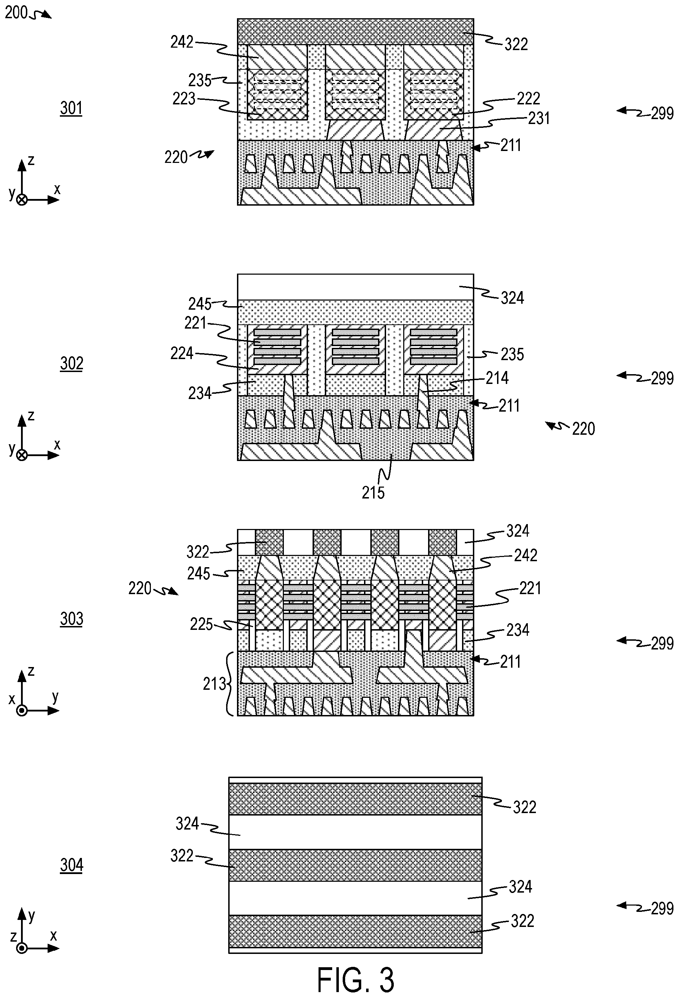

FIG. 3 illustrates transistor structures 220 having alternating first and second rows of first and second sacrificial materials on the back side of substrate 299, in accordance with some embodiments, for example, following a performance of forming operation 102. Parallel and alternating first and second rows of first and second sacrificial materials 322, 324 extend in the x-direction. First sacrificial material 322 extends in the x-direction in rows on sacrificial structures 242 in views 301, 303, 304. Second sacrificial material 324 extends in the x-direction in rows on isolation structures 245 over gate electrodes 224 in views 302, 303, 304. As shown in view 301, first rows of first sacrificial material 322 span or bridge over isolation structures 245 between sacrificial structures 242.

Returning to FIG. 1, methods 100 continue by replacing the first sacrificial material in the first rows with a first dielectric material at operation 103. Gaps are opened over the sacrificial structures by removing the first sacrificial material on the sacrificial structures. The first sacrificial material may be removed from the sacrificial structures, e.g., by selectively stripping off the first BCP from between the second rows of the second sacrificial material.

The first sacrificial material is replaced by depositing a dielectric material in the gaps left by the first sacrificial material between the retained second rows of the second sacrificial material. The first dielectric material may be any suitable dielectric material and may be deposited by any suitable means. The first dielectric material may include silicon (for example, in an oxide, nitride, carbide, etc., of silicon). The first dielectric material will advantageously have an etch selectivity with subsequent dielectric structures, which may include oxygen. In many embodiments, the first dielectric material will act as a hardmask and includes silicon and nitrogen. In some embodiments, the first dielectric material is deposited conformally over the sacrificial structures and the second sacrificial material. In some such embodiments, the first dielectric material is deposited by an atomic layer deposition (ALD). In some embodiments, the first dielectric material is deposited above a top surface of the second sacrificial material and is subsequently recessed back down. In some such embodiments, a polish (e.g., CMP) or etch is used to recess back the first dielectric material down to the level of, and to expose, the second sacrificial material.

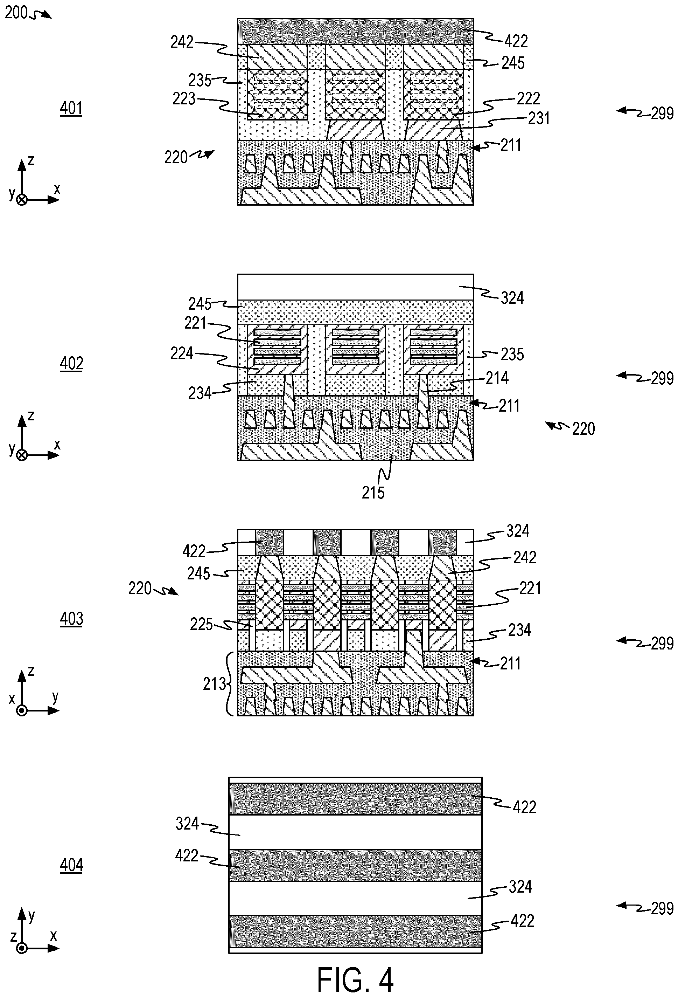

FIG. 4 shows alternating first rows of first dielectric material 422 and second rows of second sacrificial material 324 on the back side of substrate 299, in accordance with some embodiments, for example, following performances of replacing operation 103. Parallel and alternating first rows of first dielectric material 422 and second rows of second sacrificial material 324 extend in the x-direction. First dielectric material 422 extends in the x-direction in rows on sacrificial structures 242 in views 401, 403, 404. Second sacrificial material 324 extends in the x-direction in rows on isolation structures 245 over gate electrodes 224 in views 402, 403, 404. A top surface of dielectric material 422 and material 324 has been planarized, as shown in view 403.

First dielectric material 422 is on (e.g., in contact with) sacrificial structures 242, as shown in views 401, 403. Dielectric material 422 is an insulator structure over sacrificial structures 242 (while substrate 299 is inverted), between sacrificial structures 242 and the back side of substrate 299. Material 422 may include silicon (for example, in an oxide, nitride, carbide, etc., of silicon). First dielectric material 422 may be used as a hardmask and advantageously has an etch selectivity with adjacent dielectric structures, such as isolation structures 245 adjacent and between sacrificial structures 242. In many embodiments, dielectric material 422 includes silicon and nitrogen.

Returning to FIG. 1, methods 100 continue with removing the second rows of second sacrificial materials on the dielectric or isolation structures over the gate electrodes at operation 104. Gaps are opened between the first rows of first dielectric material by removing the second sacrificial material over the dielectric material of the isolation structure on the gate electrodes. The second sacrificial material may be removed from over the isolation structure, e.g., by stripping off or plasma ashing of the second BCP from between the rows of gate insulators.

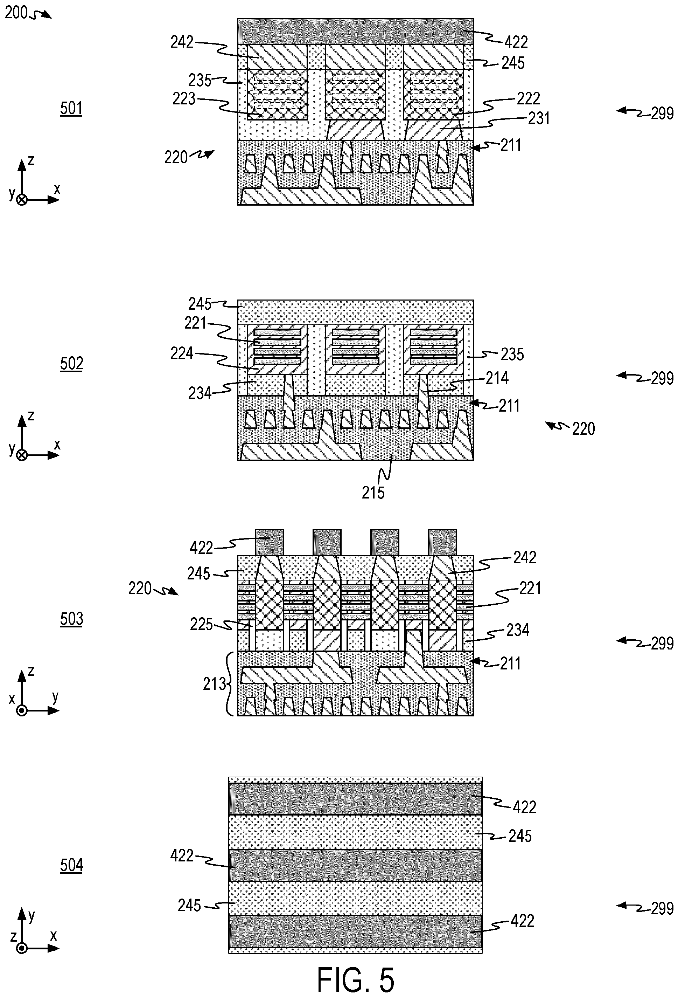

FIG. 5 shows gaps between first rows of first dielectric material 422 on the back side of substrate 299, in accordance with some embodiments, for example, following a performance of removing operation 104. Hardmask dielectric material 422 is over sacrificial structures 242 (as shown in at least views 501, 503). No sacrificial material is present over (isolation structures 245 on) gate electrodes 224 (as shown in at least views 502, 503), and isolation structure 245 is exposed in gaps between hardmask material 422 (as shown in at least view 503). Note that view 504 (as well as some other plan views to follow) is not strictly of a single x-y viewing plane, e.g., level with a top surface of view 503. In addition to hardmask material 422 on an upper x-y plane, dielectric material of isolation structure(s) 245 on a lower x-y plane is shown through openings or gaps between first rows of hardmask material 422 over sacrificial structures 242.

Returning to FIG. 1, methods 100 continue at operation 105 by exposing certain portions of the transistor structures by etching between the first rows of dielectric material. The exposed portions may subsequently be contacted and coupled to a back-side interconnect network. In many embodiments, the portions to be exposed are the gate electrodes. In some embodiments, only some (e.g., a partial set) of the transistor structures have these certain portions exposed. For example, in some embodiments, the certain portions to be exposed are gate electrodes, and some of the transistor structures have front-side gate contacts and do not need exposing the back sides of their gate electrodes.

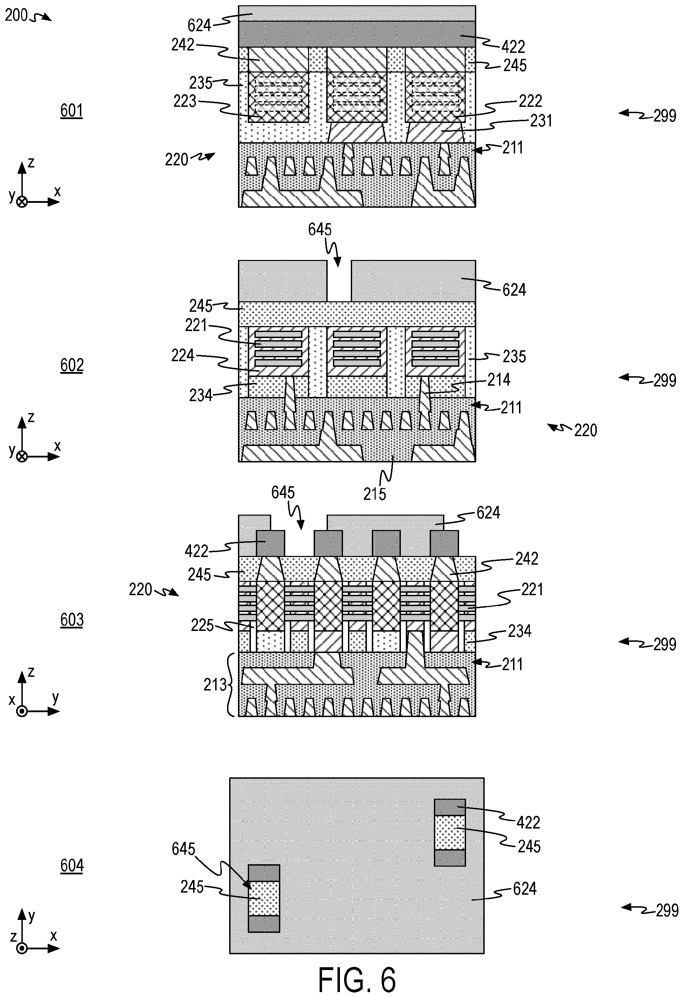

The etching between first rows of dielectric material may use photolithographic patterning. The etching may be performed by any suitable means, for example, by anisotropic dry etching. The dry etch may be by, e.g., a reactive ion etch (RIE), such as a deep RIE (DRIE). By using etch selectivities between the dielectric material of the first rows and the dielectric or isolation material over the gate electrodes and between the sacrificial structures, the etching may be effectively self-aligned with the respective gate electrodes to be exposed. In at least embodiments utilizing directed self-assembly of monolayers at operation 102, the first rows (and their dielectric mask material) were precisely (e.g., nearly perfectly) aligned (by the corresponding sacrificial materials) over the drain and source regions and the sacrificial structures over the drain and source regions. The gate electrodes are nearly perfectly aligned between the first rows of dielectric mask material (under a dielectric material between the sacrificial structures). The etching through the dielectric material between the sacrificial structures may then be done through the opening between the first rows using an etch selective to the dielectric mask material of the first rows. The back-side contacts to be formed are effectively self-aligned because any patterning and etching has advantageously large margins for placement errors (etc.) either due to relatively large structural dimensions in the x-directions (for example, in FIG. 6, e.g., along a long dimension of drain and source regions or gate electrodes in views 601, 602, respectively) or, moving in the y-directions, due to the etch selectivities between rows of materials.

FIG. 6 shows a lithographic mask layer 624 over hardmask material 422 and isolation structure(s) 245 on the back side of substrate 299, in accordance with some embodiments, for example, during a performance of exposing operation 105. Lithographic mask layer 624 is over hardmask material 422 (e.g., in view 601). Although the opening 645 in lithographic mask layer 624 may not be self-aligned in the x-dimension, patterned etches have relatively large targets (e.g., long dimensions of gate electrodes 224) to aim at (e.g., as shown in view 602). Opening 645 in mask layer 624 may be effectively self-aligned in the y-dimension, as patterned etches may utilize an etch selectivity and hardmask material 422 to funnel an etch between first rows of hardmask material 422 (e.g., as shown in view 603). A longer length of pattern opening 645 in the y-dimension is contained by hardmask material 422 during an etch of isolation structure(s) 245. View 604 shows the self-aligned portion of opening 645 constrained to a shorter length at isolation structure(s) 245 than at mask layer 624 (e.g., in the y-dimension).

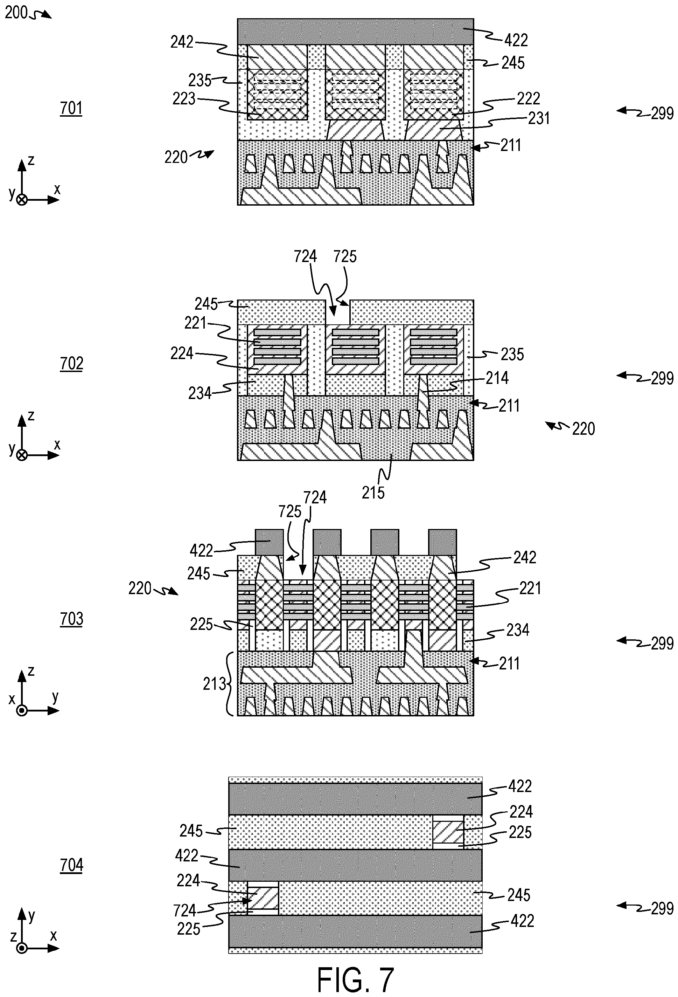

FIG. 7 shows transistor structure 220 having gate electrode 224 with an exposed portion 724 on the back side of substrate 299, in accordance with some embodiments, for example, following a performance of exposing operation 105. No lithographic mask layer 624 is over hardmask material 422 or isolation structure(s) 245 (e.g., as shown in views 701, 702, 703, 704). Exposed portion 724 of gate electrode 224 is between or surrounded by isolation structure(s) 245 (e.g., as shown in views 702, 703, 704). Gate electrode 224 has exposed portion 724 between sacrificial structures 242 and first rows of hardmask material 422 (e.g., as shown in view 703). View 704 shows exposed portion 724 of electrode 224 through isolation structure(s) 245 and between rows of hardmask material 422 (e.g., in the y-dimension).

In some embodiments, the etching between the first rows of hardmask material 422 exposes a hole sidewall 725 over gate electrode 224 and adjacent sacrificial structure 242. In some such embodiments, a spacer layer of a dielectric material is formed (e.g., deposited) on exposed hole sidewall 725. A spacer layer, e.g., advantageously of a low-K dielectric material, may ensure sufficient electrical isolation is between the eventual back-side contact to gate electrode 224 and any back-side contact to adjacent drain and source regions 222, 223. A spacer layer may be substantially conformally deposited on the hole sidewall(s). The spacer layer may be formed by physical vapor deposition (PVD), which enables a larger thickness of dielectric to be deposited on upper, horizontal surfaces of the gate insulators, which may in turn allow a subsequent anisotropic etch to expose upper surfaces of drain and source regions.

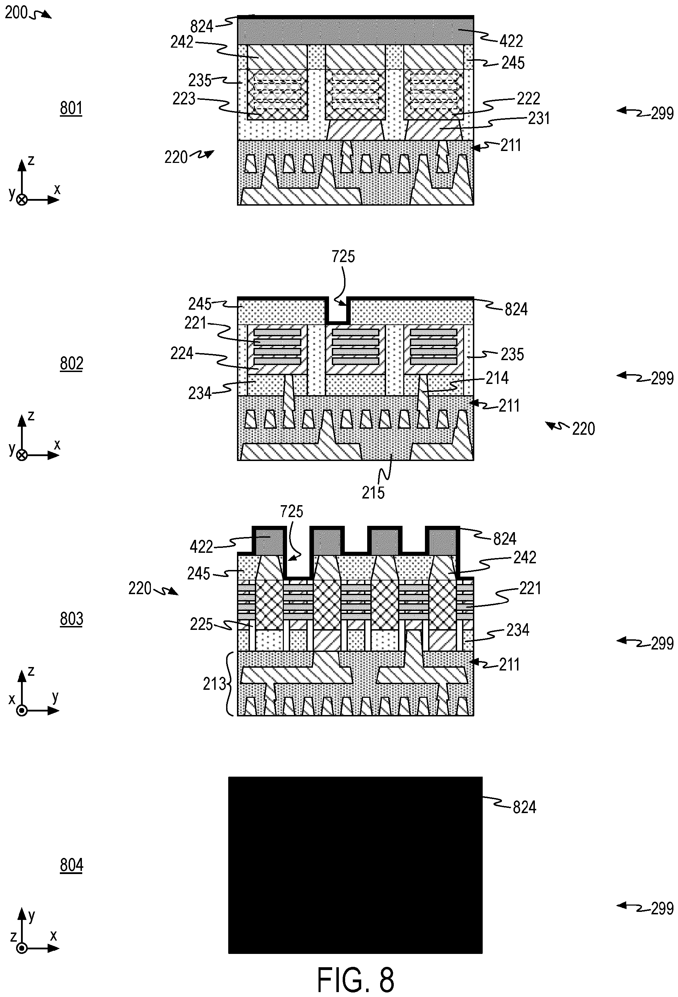

FIG. 8 illustrates transistor structures 220 having spacer layer 824 conformally over hole sidewall 725 and other structures on the back side of substrate 299, in accordance with some embodiments, for example, while forming back-side contacts with spacer layers between adjacent structures. View 801 shows layer 824 over hardmask material 422. View 802 shows layer 824 over isolation structure 245, including on hole sidewall(s) 725 and on gate electrode 224. View 803 shows layer 824 over isolation structure 245 and first rows of hardmask material 422, including on hole sidewall(s) 725 (adjacent sacrificial structures 242) and on gate electrode 224. View 804 shows layer 824 over all of substrate 299.

Spacer layer 824 may include silicon (for example, in an oxide, nitride, carbide, etc., of silicon). Spacer layer 824 advantageously has an etch selectivity with adjacent dielectric structures, such as isolation structure 245. In many embodiments, spacer layer 824 includes silicon, oxygen, carbon, and nitrogen.

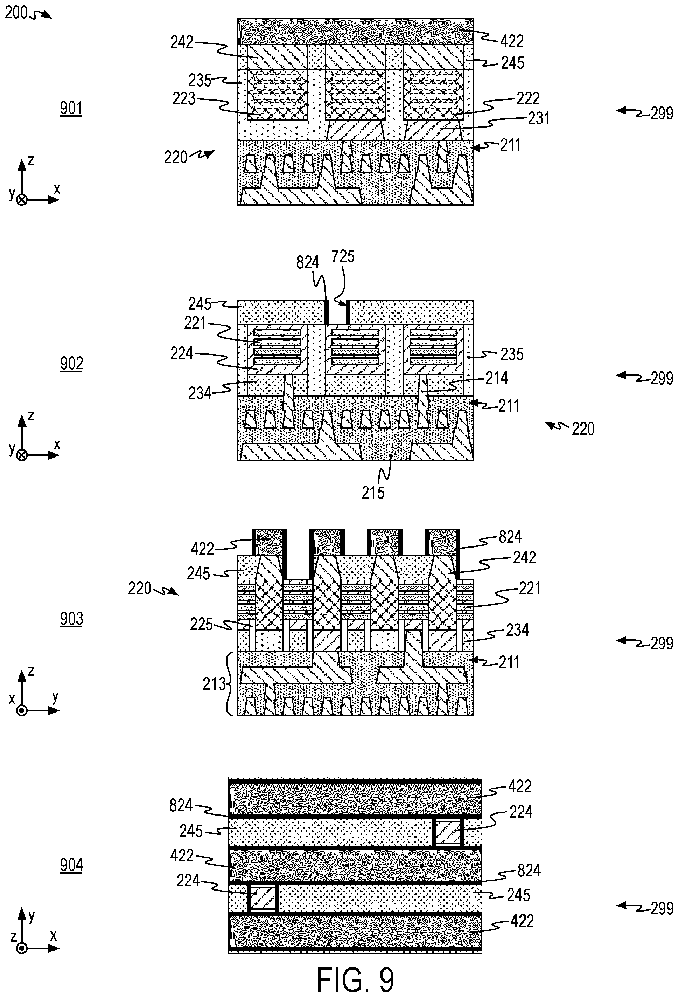

FIG. 9 shows transistor structures 220 having spacer layer 824 conformally over hole sidewall 725 on the back side of substrate 299, in accordance with some embodiments, for example, while forming back-side contacts with spacer layers between adjacent structures. View 901 shows no layer 824 over hardmask material 422. View 902 shows layer 824 only on isolation structure 245 on hole sidewall(s) 725. View 903 shows spacer layer 824 on sidewalls of isolation structure 245 and first rows of hardmask material 422, e.g., at hole sidewall(s) 725 (adjacent sacrificial structures 242). View 904 shows layer 824 at hole sidewall(s) 725, as well as sidewalls of first rows of hardmask material 422 on substrate 299.

Returning to FIG. 1, methods 100 continue at operation 106 with forming first contacts (e.g., on a back side, opposite the interconnect or metallization layer) to the exposed portions (e.g., at least some gate electrodes) of the transistor structures. The contacts or vias may be formed to the portions exposed at operation 105, e.g., by etching between the first rows of dielectric or hardmask materials. As described, at least at operation 105, some of the gate electrodes may be contacted on the front side, and so may not be contacted on the back side.

The back-side contacts to the exposed portions of at least some of the gate electrodes and the drain and source regions may be formed by any suitable means, for example, by deposition of a conductive material, such as a metal. The deposition may be by, e.g., a PVD or chemical vapor deposition (CVD). Back-side contacts may include the same or other materials (e.g., metals, such as tungsten and molybdenum) described for front-side interconnect or metallization layers, for example, at FIGS. 1 (e.g., at operation 101) and 2 (e.g., about layer 211). In at least some embodiments, as described elsewhere herein, a second interconnect or metallization network is formed on the back side, and the back-side interconnect or metallization network is coupled to the back-side contacts (e.g., described here, at operation 106, and other) and to the first metallization network on the front side. In some embodiments, the first contacts are recessed in preparation for subsequent processing (e.g., such as forming back-side interconnect or metallization network, etc.).

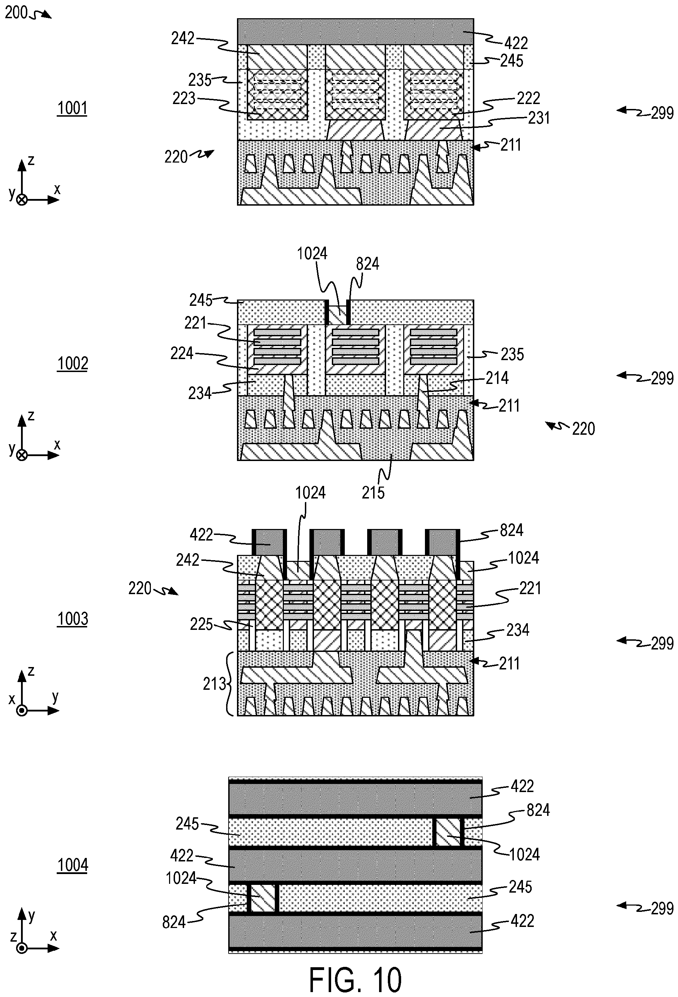

FIG. 10 illustrates transistor structures 220 having self-aligned metal contacts 1024 over gate electrodes 224 on the back side of substrate 299, in accordance with some embodiments, for example, following a performance of forming operation 106. In some embodiments, as shown, contacts 1024 are recessed back, e.g., in preparation for further processing. Upper surfaces of contacts 1024 are below an upper surface of isolation structure 245 (e.g., as shown at views 1002, 1003, 1004). In other embodiments, first contacts 1024 are not recessed (e.g., to below isolation structure 245). Contacts 1024 are between first rows of hardmask material 422 (e.g., as shown at views 1003, 1004, and not shown at view 1001).

In some embodiments, dielectric first caps are formed over the first back-side contacts. In some such embodiments, the forming the first caps includes depositing a dielectric material (for example, in an oxide, nitride, carbide, etc., of silicon) over the first contacts (e.g., over recessed first contacts). Advantageously, the first caps have an etch selectivity with adjacent dielectric structures, such as an isolation structure adjacent the gate electrodes and between the sacrificial structures on the drain and source regions. The dielectric may be deposited conformally over the first back-side contacts, spacer layer, etc. Some of this conformal deposition (e.g., excess deposition, not on the first back-side contacts) may be removed by any suitable means. In some embodiments, excess deposited dielectric is removed by CMP.

Returning to FIG. 1, methods 100 continue at operation 107 by removing the first rows of the first dielectric material. The removing the first dielectric material may expose and make accessible the sacrificial structures on the drain and source regions, under the first rows of the first dielectric material. The first dielectric material may be removed by any suitable means. In some embodiments, the first dielectric material is removed by CMP. In some such embodiments, the CMP also planarizes first contacts. In some embodiments, the CMP also planarizes first caps over first contacts.

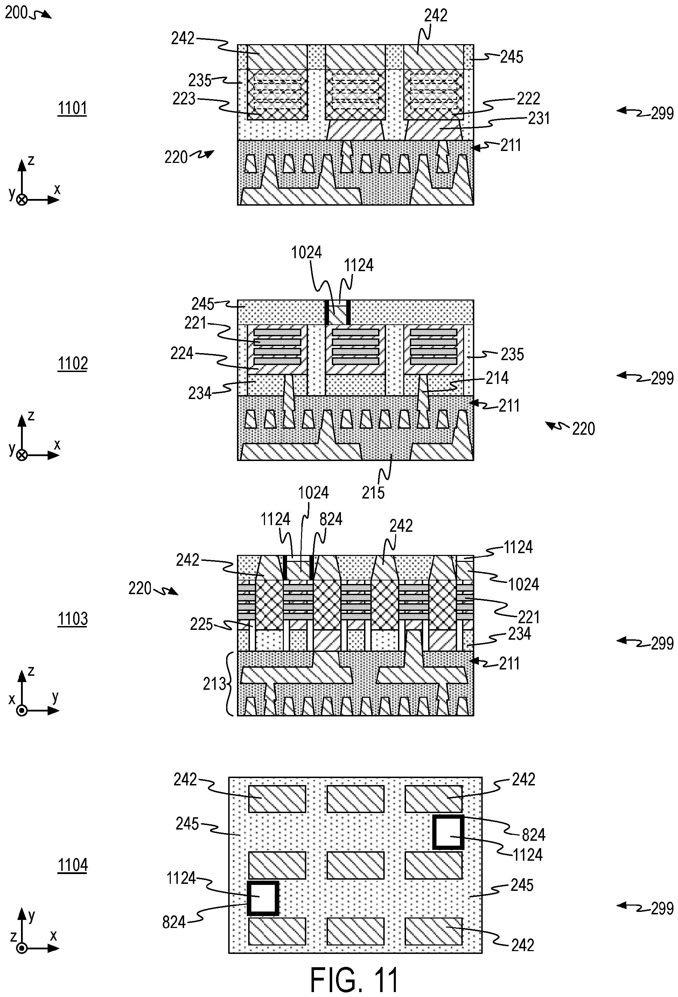

FIG. 11 shows transistor structures 220 having dielectric caps 1124 over metal contacts 1024 over gate electrodes 224 on the back side of substrate 299, in accordance with some embodiments, for example, following a performance of removing operation 107. Note spacer layer 824 between first contacts 1024 and, e.g., adjacent sacrificial structures 242. No first rows of hardmask material 422 are over sacrificial structures 242. Sacrificial structures 242 are exposed on a top surface of substrate 299 (e.g., at the top of cross-sectional views 1101, 1103 and in the plan view of 1104). Back-side gate contacts 1024 connect to gate electrodes 224 under dielectric caps 1124. Back-side gate contacts 1024 connecting to gate electrodes 224 not apparently contacted may or may not be shown in view 1103, e.g., depending on the position of contacts 1024 in the x-dimension relative the plane of view 1103.

Gate dielectric caps 1124 are on back-side gate contacts 1024, as shown in views 1102, 1103. First cap 1124 is an insulator structure over gate contacts 1024, between and flush with isolation structure 245. First cap 1124 may include silicon (for example, in an oxide, nitride, carbide, etc., of silicon) and advantageously has an etch selectivity with adjacent structures, such as sacrificial structures 242.

Returning to FIG. 1, methods 100 continue at operation 108 by replacing the sacrificial structures with dielectric plugs and second contacts. The sacrificial metal structures are now exposed on the back side. The second contacts may be back-side contacts to second portions (e.g., those not already contacted on the back side) of a second set of the transistor structures. For example, the second portions to be contacted may be source and/or drain regions of transistor structures (whether contacted to a gate electrode on the front- or back-side). The second set may overlap with the first (for example, where some transistor structures are contacted on the back-side to the gate electrode and one or both of the source and drain regions), but the second set may include some transistor structures in the first set (e.g., transistor structures contacted on the back-side to one or both of the source and drain regions, but not contacted on the back-side to the gate electrode).

Some sacrificial structures may be removed and replaced with dielectric plugs. The sacrificial structures may be removed by any suitable means, e.g., a wet etch or isotropic dry etch that is selective to all other exposed materials. A masking operation (e.g., using a photolithographic mask) may be used to distinguish between sacrificial structures to be replaced with plugs and other sacrificial structures (e.g., to be replaced with contacts). Dielectric plugs may be formed in the openings vacated by removal of the sacrificial structures. The plugs may be formed by any suitable means and of any suitable (e.g., electrically insulating) materials. The plugs may advantageously be formed of low-K materials. The dielectric plugs may include silicon (for example, in an oxide, nitride, carbide, etc., of silicon).

In many embodiments, plugs are formed by the conformal deposition of a dielectric material that includes at least silicon and oxygen. The dielectric material may be deposited in a conformal layer with substantially equal or constant thicknesses over the sidewalls of the vacated openings (as well as other exposed surfaces of the substrate) such that the deposited dielectric material over each opening sidewall meets near a centerline of the vacated openings. A seam may be detectable at the meeting of the dielectric material layer on each sidewall. The dielectric material may be recessed (e.g., by CMP) down to expose the surfaces of the substrate under the conformal dielectric layer. The seam may persist on a recessed surface of the dielectric material, e.g., even after a planarization, etc. The seam may also be detectable extending from the (e.g., planarized) surface of the dielectric material into the dielectric structure, toward a bulk of the dielectric plug (e.g., in the volume vacated by the sacrificial structure). The presence of the seam on the back side of the dielectric plug (the side opposite the side of the plug contacting the source or drain region) may indicate that the plug was formed from the back side (e.g., rather than from the front side before a back-side reveal).

Some sacrificial structures may be removed and replaced with second contacts, for example, to source and/or drain regions and on the back side of the transistor structures. The sacrificial structures may be removed by any suitable means, e.g., a selective wet or isotropic dry etch as previously described. The sacrificial structures to be replaced by second contacts may be before, after, or concurrently with the sacrificial structures to be replaced by dielectric plugs. Second contacts to selected source and/or drain regions may be formed in the openings vacated by removal of the sacrificial structures. The contacts may be formed by any suitable means (e.g., by a PVD or CVD) and of any suitable (e.g., electrically conducting) materials, such as metals. The substrate may be planarized after the metal deposition. Back-side contacts may include the same or other materials (e.g., metals, such as tungsten and molybdenum) described for back-side gate contacts (e.g., at operation 106) or front-side interconnect or metallization layers, for example, at FIGS. 1 (e.g., at operation 101) and 2 (e.g., about layer 211). Back-side second contacts, e.g., to source and/or drain regions may additionally include other metals or other materials to facilitate a satisfactory mechanical and electrical connection to a semiconductor material source and drain regions. For example, second contacts may include silicon in an alloy with a metal (such as titanium, etc.).

In some embodiments, dielectric second caps are formed over the second contacts. In some such embodiments, the second caps are formed over the second contacts by depositing a dielectric material of the second caps that has an etch selectivity with the dielectric material of the first caps. In some embodiments, the dielectric is deposited after the contact has been recessed down to below the back side of the substrate. The substrate may be planarized after the dielectric deposition.

The etch selectivity between the dielectric materials of the first and second caps may facilitate separate interconnecting of the first and second contacts. The etch selectivity between the first and second caps may also provide an effective self-alignment of vias contacting the first and second contacts. By using a selective etch to form vias contacting the first or second contacts, an additional margin for patterning or placement error may be provided. For example, an etch selective to one of the first or second caps may be somewhat misaligned but still not remove an unintended other cap. ISE where a back-side interconnect or metallization network is formed, first and second selective etches of the first and second caps, respectively, are employed. The first selective etch of the dielectric material of the first caps may be employed to remove the first caps before coupling the first contacts to the back-side interconnect network. The second selective etch of the dielectric material of the second caps may be employed to remove the second caps before coupling the second contacts to the back-side interconnect network.

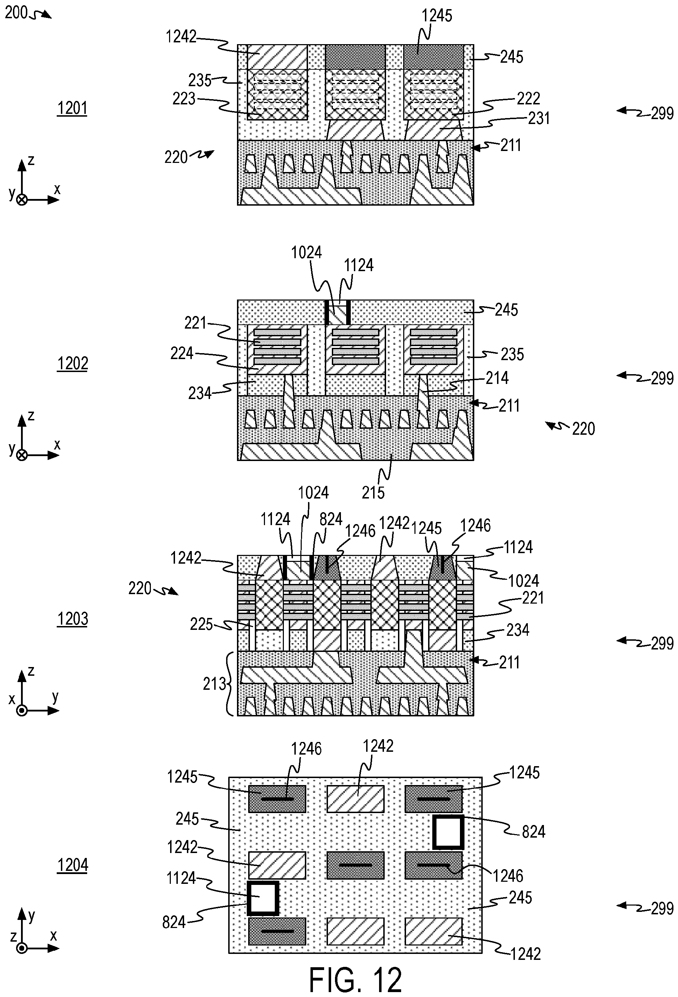

FIG. 12 illustrates transistor structures 220 having back-side contacts 1024, 1242 to some gate electrodes 224 and drain and source regions 222, 223 and dielectric plugs 1245 over other drain and source regions 222, 223, in accordance with some embodiments, for example, following a performance of replacing operation 108. All (previously shown) sacrificial structures 242 are absent from substrate 299 and device 200. Some of drain and source regions 222, 223 are contacted by back-side contacts 1242 (e.g., as shown at views 1201, 1203). Others of drain and source regions 222, 223 are contacted by front-side contacts 231 and in contact with dielectric plugs 1245 on a back side of substrate 299. Some of gate electrodes 224 are contacted by back-side contacts 1024 (e.g., as shown at views 1202, 1203). Others of gate electrodes 224 are contacted by front-side contacts or vias 214. Back-side contacts 1024 are covered by first caps 1124 (e.g., as shown at views 1202, 1203, 1204).

Dielectric plugs 1245 include seams 1246 (e.g., as shown at views 1203, 1204). Seams 1246 are on or intersecting the back sides of plugs 1245, opposite the side in contact with the first of the source and drain regions. Seam 1246 extends from the back side of plugs 1245 into plugs 1245, toward a bulk of plugs 1245.

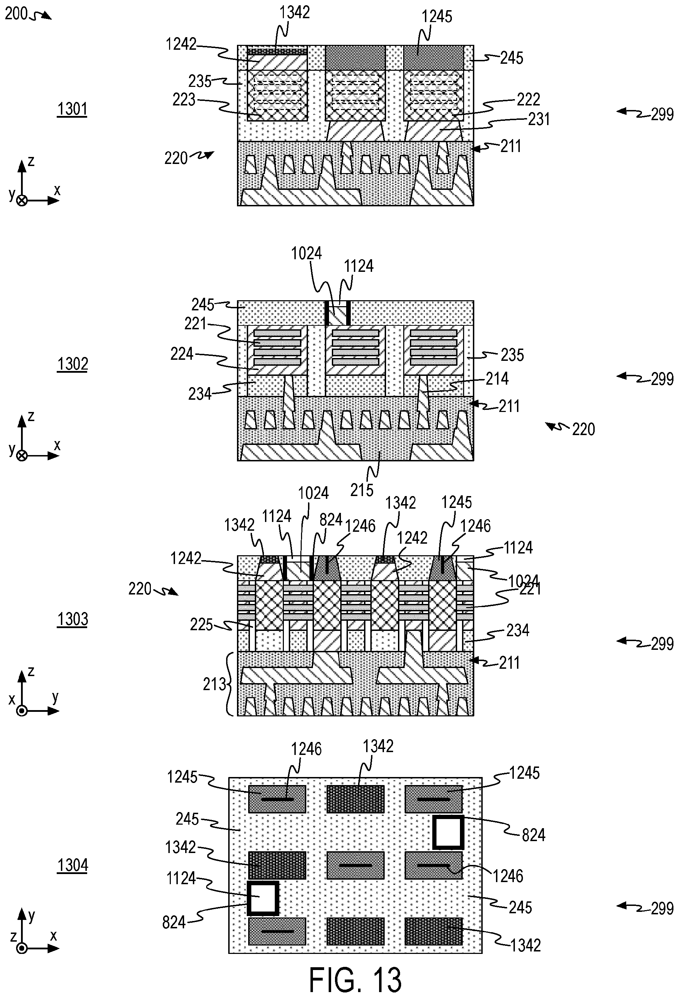

FIG. 13 illustrates having first and second dielectric caps 1124, 1342 over back-side first and second contacts 1024, 1242 to transistor structures 220, in accordance with some embodiments, for example, following a performance of replacing operation 108. Back-side contacts 1242 to drain and source regions 222, 223 have second caps 1342 and recessed upper surfaces (e.g., to below the back side of substrate 299, as shown at views 1301, 1303). Back-side contacts 1024 to gate electrodes have first caps 1124 and recessed upper surfaces (e.g., to below the back side of substrate 299, as shown at views 1302, 1303).

View 1304 shows the back side of substrate 299 with dielectric structure 245 between first and second dielectric caps 1124, 1342 and dielectric plugs 1245. In some embodiments, etch selectivities exist between each of structure 245, caps 1124, 1342, and plugs 1245. These etch selectivities enable precise control of etches of selected caps 1124, 1342, e.g., to couple gate electrodes 224 or drain and source regions 222, 223, respectively, to a back-side interconnect network.

In some embodiments, an interconnect network is formed on the back side of the substrate, opposite the front-side interconnect network. In some such embodiments, the back-side interconnect network is coupled to the front-side interconnect network and to the first and second back-side contacts to gate electrodes and drain and source regions. Back-side interconnect or metallization layers may be formed by patterning, etching, and metallizing similar to that used for forming back-side contacts or front-side interconnect or metallization layers. Subsequent layers of dielectric materials may be built up iteratively, one over another, after a previous, lower interconnect layer is patterned and metallized.

Returning to FIG. 1, methods 100 continue at operation 109 by outputting IC device 200. Outputting device 200 may include sending device 200 on to subsequent operations on substrate 299 (such as dicing, bonding, packaging, etc.). Other operations may be employed.

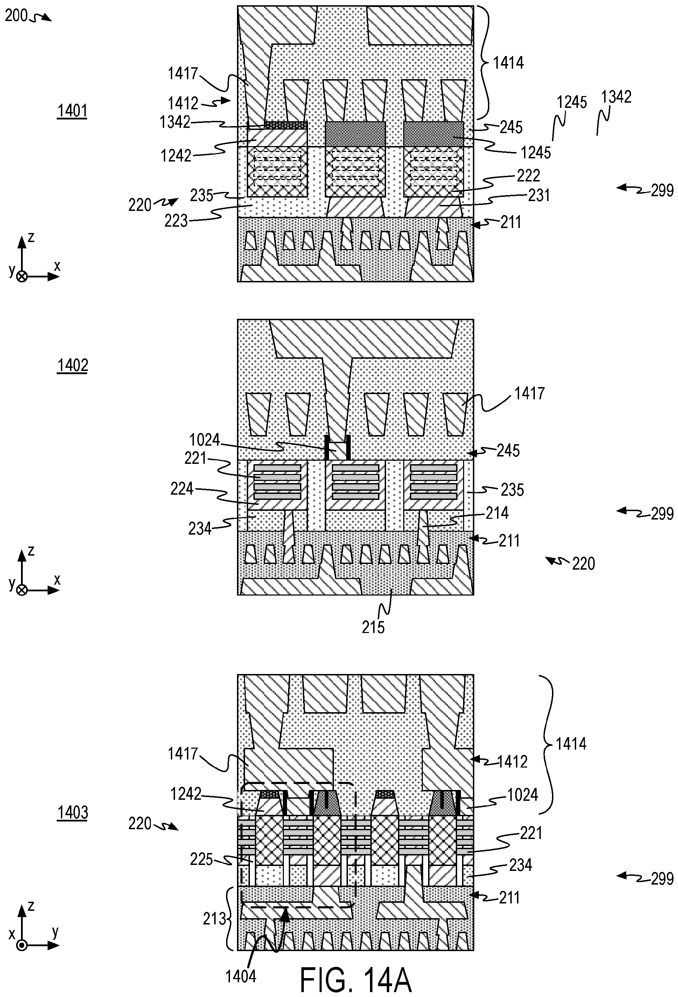

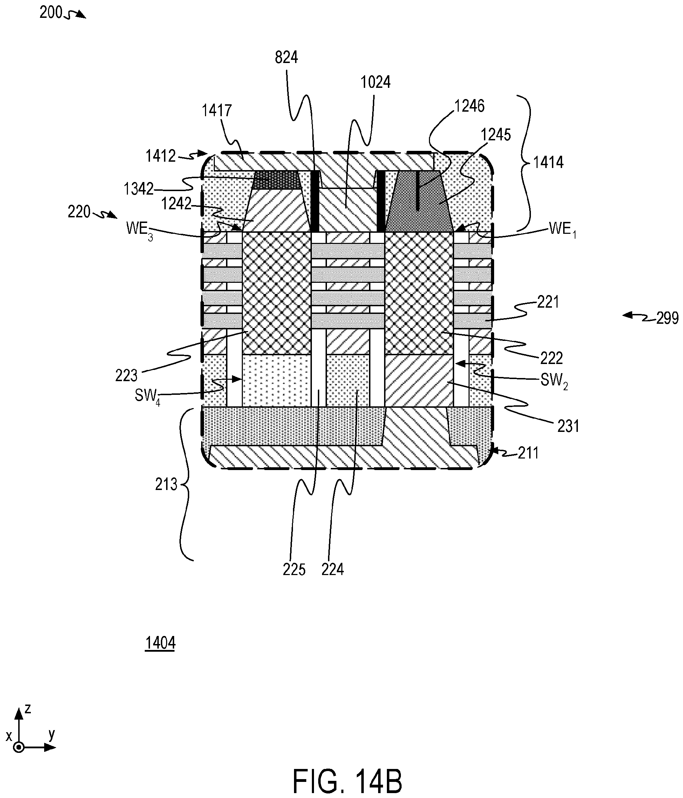

FIGS. 14A and 14B illustrate cross-sectional profile views of transistor structures 220 between and coupled to front- and back-side interconnect layers 211, 1412 and networks 213, 1414, in accordance with some embodiments. FIG. 14A (and views 1401, 1402, 1403) shows some of drain and source regions 222, 223 are coupled to front-side layers 211 and network 213 (e.g., through contacts 231), and some of drain and source regions 222, 223 are coupled to back-side layers 1412 and network 1414 (e.g., through contacts 1242). Some of gate electrodes 224 are coupled to front-side layers 211 and network 213 (e.g., through contacts or vias 214), and some of gate electrodes 224 are coupled to back-side layers 1412 and network 1414 (e.g., through contacts 1024).

View 1401 shows second cap 1342 separating back-side contact 1242 from one of metal lines 1417 in interconnect layer 1412 and network 1414, but also back-side contact 1242 coupled to another of metal lines 1417. Dielectric plugs 1245 isolate front-side contacted drain and source regions 222, 223 from metal lines 1417 in back-side layer 1412.

View 1402 shows back-side contact 1024 coupling gate electrode 224 to one of metal lines 1417 in back-side layer 1412. Isolation structures 245 may be part of the dielectrics in interconnect network 1414.

View 1403 shows second cap 1342 separating back-side contact 1242 from one of metal lines 1417. Dielectric plugs 1245 isolate front-side contacted drain and source regions 222, 223 from metal lines 1417 in back-side layer 1412. Back-side contact 1024 couples gate electrode 224 to one of metal lines 1417 in back-side layer 1412.

In expanded view 1404 of FIG. 14B, a transistor structure 220 (shown in the dashed box in FIG. 14A) coupled to both layers 211, 1412 is shown in greater detail.

Back-side interconnect or metallization layers 1412 may include the same or other materials (e.g., metals and dielectrics) described for front-side interconnect or metallization layers 211, for example, at FIGS. 1 (e.g., at operation 101) and 2 (e.g., about dielectric materials 215 and other dielectric materials).

FIG. 14B and view 1404 show device 200 in greater detail, e.g., to illustrate alignments of various structures. IC device 200 includes first and second metallization layers 211, 1412. IC device 200 includes transistor structure 220 between and coupled to front- and back-side interconnect layers 211, 1412. Transistor structure 220 includes gate electrode 224 between drain and source regions 222, 223. One of drain and source regions 222, 223 (e.g., a drain region 222) is coupled to metallization layer 211. Dielectric plug 1245 is between interconnect layer 1412 and drain region 222. Dielectric plug 1245 includes seam 1246 on and intersecting a top side of plug 1245, opposite a bottom side in contact with drain region 222. Seam 1246 extends from the top side of plug 1245 into plug 1245, toward a bulk of plug 1245. The top side of dielectric plug 1245 is in contact with back-side layer 1412. Drain region 222 is coupled to front-side metallization layer 211 by front-side contact 231 in contact with drain region 222 and between drain region 222 and layer 211.

Another of drain and source regions 222, 223 (e.g., a source region 223) is coupled to back-side metallization layer 1412 by back-side contact 1242 in contact with source region 223 and between source region 223 and layer 1412. (Source region 223 is coupled to back-side layer 1412 by back-side contact 1242 by a via behind the viewing plane, similar to back-side contact 1242 under cap 1342 in view 1401.)

A first sidewall or first widest edge WE₁ of dielectric plug 1245 is precisely vertically aligned with a second sidewall SW₂ of front-side contact 231. A third sidewall or third widest edge WE₃ of back-side contact 1242 is precisely vertically aligned with a fourth sidewall SW₄ of second cap 1342 between source region 223 and layer 211.

Gate electrode 224 is coupled to back-side layer 1412 by gate contact 1024 in contact with gate electrode 224 and between electrode 224 and layer 1412. Gate electrode 224 is between first and second spacer layers 824. First and second spacer layers 824 are between dielectric plug 1245 and back-side contact 1242. Drain region 222 is coupled to front-side layer 211 by front-side contact 231 in contact with drain region 222 and between layer 211 and drain region 222. Source region 223 is coupled to front-side layer 211 by back-side contact 1242 in contact with source region 223 and between layer 211 and source region 223. Gate electrode 224 is coupled to back-side interconnect layer 1412 by gate contact 1024 in contact with electrode 224 and between back-side layer 1412 and electrode 224.

Gate electrode 224 is coupled to metal line 1417 in back-side layer 1412 by gate contact 1024 in contact with electrode 224. Dielectric plug 1245 is between and in contact with metal line 1417 and drain region 222. Second cap 1342 is between and in contact with metal line 1417 and source region 223. Dielectric plug 1245 has a first composition different than a second composition of cap 1342. For example, in many embodiments, plug 1245 includes mostly of silicon and oxygen, and cap 1342 includes mostly silicon and carbon or mostly silicon and nitrogen.

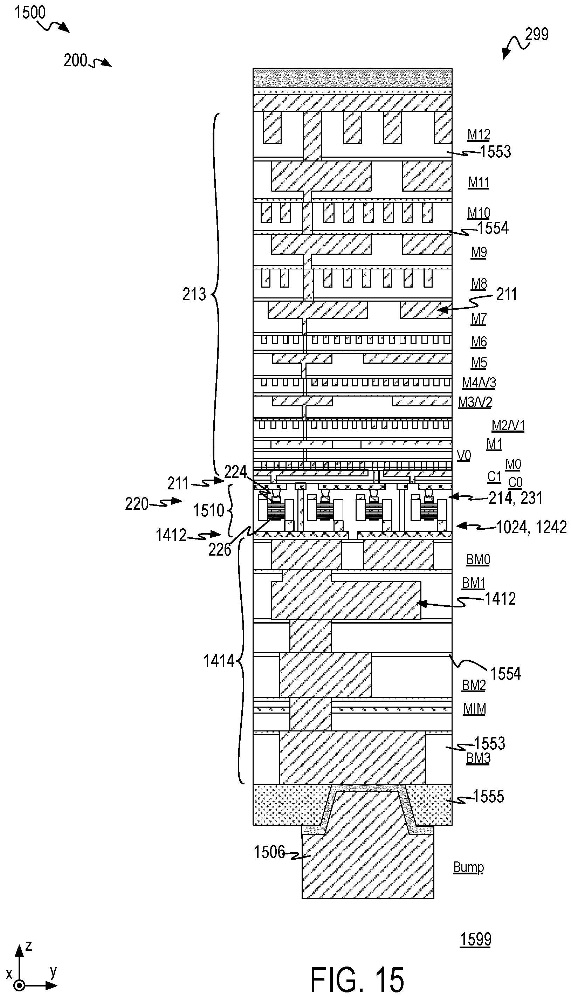

FIG. 15 illustrates a cross-sectional profile view of IC system 1500 having transistor structures 220 with front- and back-side contacts 231, 1024, 1242 and vias 214 to front- and back-side interconnect layers 211, 1412, in accordance with some embodiments. In the example of IC system 1500, IC die or other substrate 299 includes transistor structures 220 having interconnections between front-side layers 211 in front-side interconnect network 213 and back-side layers 1412 in back-side interconnect network 1414. IC system 1500 includes a lateral surface along the x-y plane that may be defined or taken at any vertical position of IC system 1500. The lateral surface of the x-y plane is orthogonal to a vertical or build-up dimension as defined by the z-axis. In some embodiments, IC system 1500 may be formed from any substrate material suitable for the fabrication of transistor circuitry. In some embodiments, a semiconductor substrate is used to manufacture transistor structures 220 and other transistors and components of IC system 1500. The semiconductor substrate 299 may include a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as gallium arsenide. The substrate may also include semiconductor materials, metals, dielectrics, dopants, and other materials commonly found in semiconductor substrates.

In FIG. 15, IC system 1500 includes an IC die or substrate 299, which is a monolithic IC as described above, including transistor structures 220 and various contacts and vias through insulating layers and other structures, front-side metallization layers 211 (or front-side interconnect layers), and back-side metallization layers 1412 (or back-side interconnect layers). As shown, transistor structures 220 are embedded within a dielectric layer 1510. As shown, each transistor structure 220 includes channel regions 226 (e.g., within fins, nanoribbons, etc.) and gate electrodes 224. Each of transistor structures 220 also include source and drain regions and source and drain contacts. In some embodiments, front-side metallization layers 211 provide signal routing to transistor structures 220 and back-side metallization layers 1412 provide power delivery, as enabled by back-side contacts 1242, etc., to transistor structures 220.

Interconnectivity of transistor structures 220 (and other transistors, etc.), signal routing to and from memory arrays, etc., power delivery, etc., and routing to an outside device (not shown), is provided by front-side metallization layers 211 and network 213, back-side metallization layers 1412 and network 1414, and package-level interconnects 1506. In the example of FIG. 15, package-level interconnects 1506 are provided on or over a back-side of IC die or substrate 299 as bumps over a passivation layer 1555, and IC system 1500 is attached to a substrate 1599 (such as a package substrate 1599) and coupled to signal routing, power delivery, etc., by package-level interconnects 1506. Front- and back-side interconnect networks 213, 1414 (including metallization layers 211, 1412) are coupled to substrate 1599. In some embodiments, interconnect networks 213, 1414 (including metallization layers 211, 1412) are coupled to a power supply through substrate 1599. However, package-level interconnects 1506 may be provided using any suitable interconnect structures such as bond pads, solder bumps, etc. Furthermore, in some embodiments, package-level interconnects 1506 are provided on or over a front-side of IC die or substrate 299 (i.e., over front-side metallization layers 211).

In the illustrated example, front-side metallization layers 211 include M0, V0, M1, M2/V1, M3/V2, M4/V3, and M4-M12. However, front-side metallization layers 211 may include any number of metallization layers such as eight or more metallization layers. Similarly, back-side metallization layers 1412 include BM0, BM1, BM2, and BM3. However, back-side metallization layers 1412 may include any number of metallization layers such as two to five metallization layers. Front-side metallization layers 211 and back-side metallization layers 1412 are embedded within dielectric materials 1553, 1554. Furthermore, optional metal-insulator-metal (MIM) devices such as diode devices may be provided within back-side metallization layers 1412. Other devices such as capacitive memory devices may be provided within front-side metallization layers 211 and/or back-side metallization layers 1412.

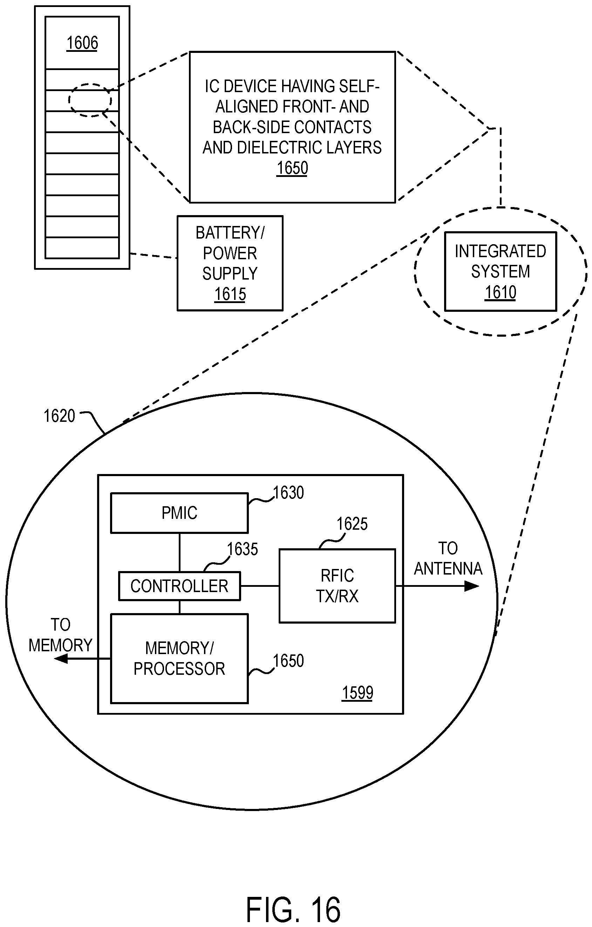

FIG. 16 illustrates a diagram of an example data server machine 1606 employing an IC device having self-aligned front- and back-side contacts and dielectric layers, in accordance with some embodiments, e.g., formed by replacing SAM sacrificial materials. Server machine 1606 may be any commercial server, for example, including any number of high-performance computing platforms disposed within a rack and networked together for electronic data processing, which in the exemplary embodiment includes one or more devices 1650 having self-aligned front- and back-side contacts and dielectric layers.

Also as shown, server machine 1606 includes a battery and/or power supply 1615 to provide power to devices 1650, and to provide, in some embodiments, power delivery functions such as power regulation. Devices 1650 may be deployed as part of a package-level integrated system 1610. Integrated system 1610 is further illustrated in the expanded view 1620. In the exemplary embodiment, devices 1650 (labeled "Memory/Processor") includes at least one memory chip (e.g., random-access memory (RAM)), and/or at least one processor chip (e.g., a microprocessor, a multicore microprocessor, or graphics processor, or the like) having the characteristics discussed herein. In an embodiment, device 1650 is a microprocessor including a static RAM (SRAM) cache memory. As shown, device 1650 may be an IC device having self-aligned front- and back-side contacts and dielectric layers, as discussed herein. Device 1650 may be further coupled to (e.g., communicatively coupled to) a board, an interposer, or a substrate 1599 along with, one or more of a power management IC (PMIC) 1630, RF (wireless) IC (RFIC) 1625 including a wideband RF (wireless) transmitter and/or receiver (TX/RX) (e.g., including a digital baseband and an analog front end module further includes a power amplifier on a transmit path and a low noise amplifier on a receive path), and a controller 1635 thereof. In some embodiments, RFIC 1625, PMIC 1630, controller 1635, and device 1650 include having self-aligned front- and back-side contacts and dielectric layers.

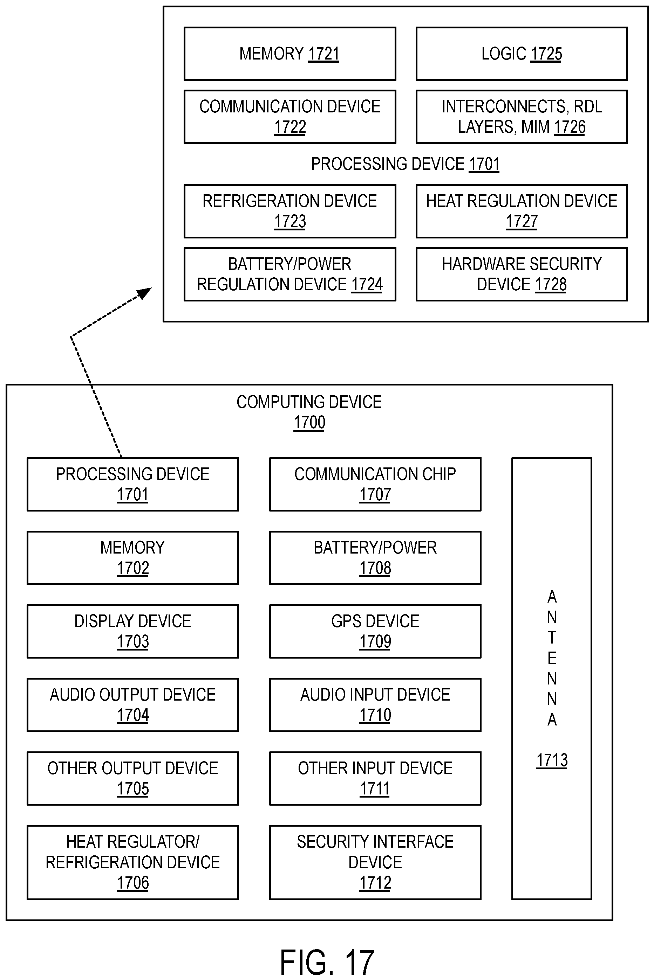

FIG. 17 is a block diagram of an example computing device 1700, in accordance with some embodiments. For example, one or more components of computing device 1700 may include any of the devices or structures discussed herein. A number of components are illustrated in FIG. 17 as being included in computing device 1700, but any one or more of these components may be omitted or duplicated, as suitable for the application. In some embodiments, some or all of the components included in computing device 1700 may be attached to one or more printed circuit boards (e.g., a motherboard). In some embodiments, various ones of these components may be fabricated onto a single system-on-a-chip (SoC) die. Additionally, in various embodiments, computing device 1700 may not include one or more of the components illustrated in FIG. 17, but computing device 1700 may include interface circuitry for coupling to the one or more components. For example, computing device 1700 may not include a display device 1703, but may include display device interface circuitry (e.g., a connector and driver circuitry) to which display device 1703 may be coupled. In another set of examples, computing device 1700 may not include an audio output device 1704, other output device 1705, global positioning system (GPS) device 1709, audio input device 1710, or other input device 1711, but may include audio output device interface circuitry, other output device interface circuitry, GPS device interface circuitry, audio input device interface circuitry, audio input device interface circuitry, to which audio output device 1704, other output device 1705, GPS device 1709, audio input device 1710, or other input device 1711 may be coupled.

Computing device 1700 may include a processing device 1701 (e.g., one or more processing devices). As used herein, the term "processing device" or "processor" indicates a device that processes electronic data from registers and/or memory to transform that electronic data into other electronic data that may be stored in registers and/or memory. Processing device 1701 may include a memory 1721, a communication device 1722, a refrigeration device 1723, a battery/power regulation device 1724, logic 1725, interconnects 1726 (i.e., optionally including redistribution layers (RDL) or metal-insulator-metal (MIM) devices), a heat regulation device 1727, and a hardware security device 1728.

Processing device 1701 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 1700 may include a memory 1702, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1702 includes memory that shares a die with processing device 1701. This memory may be used as cache memory and may include embedded dynamic random-access memory (eDRAM) or spin transfer torque magnetic random-access memory (STT-MRAM).

Computing device 1700 may include a heat regulation/refrigeration device 1706. Heat regulation/refrigeration device 1706 may maintain processing device 1701 (and/or other components of computing device 1700) at a predetermined low temperature during operation.

In some embodiments, computing device 1700 may include a communication chip 1707 (e.g., one or more communication chips). For example, the communication chip 1707 may be configured for managing wireless communications for the transfer of data to and from computing device 1700. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 1707 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1707 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1707 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1707 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1707 may operate in accordance with other wireless protocols in other embodiments. Computing device 1700 may include an antenna 1713 to facilitate wireless communications and/or to receive other wireless communications (such as AM or FM radio transmissions).

In some embodiments, communication chip 1707 may manage wired communications, such as electrical, optical, or any other suitable communication protocols (e.g., the Ethernet). As noted above, communication chip 1707 may include multiple communication chips. For instance, a first communication chip 1707 may be dedicated to shorter-range wireless communications such as Wi-Fi or Bluetooth, and a second communication chip 1707 may be dedicated to longer-range wireless communications such as GPS, EDGE, GPRS, CDMA, WiMAX, LTE, EV-DO, or others. In some embodiments, a first communication chip 1707 may be dedicated to wireless communications, and a second communication chip 1707 may be dedicated to wired communications.

Computing device 1700 may include battery/power circuitry 1708. Battery/power circuitry 1708 may include one or more energy storage devices (e.g., batteries or capacitors) and/or circuitry for coupling components of computing device 1700 to an energy source separate from computing device 1700 (e.g., AC line power).

Computing device 1700 may include a display device 1703 (or corresponding interface circuitry, as discussed above). Display device 1703 may include any visual indicators, such as a heads-up display, a computer monitor, a projector, a touchscreen display, a liquid crystal display (LCD), a light-emitting diode display, or a flat panel display, for example.

Computing device 1700 may include an audio output device 1704 (or corresponding interface circuitry, as discussed above). Audio output device 1704 may include any device that generates an audible indicator, such as speakers, headsets, or earbuds, for example.

Computing device 1700 may include an audio input device 1710 (or corresponding interface circuitry, as discussed above). Audio input device 1710 may include any device that generates a signal representative of a sound, such as microphones, microphone arrays, or digital instruments (e.g., instruments having a musical instrument digital interface (MIDI) output).

Computing device 1700 may include a GPS device 1709 (or corresponding interface circuitry, as discussed above). GPS device 1709 may be in communication with a satellite-based system and may receive a location of computing device 1700, as known in the art.

Computing device 1700 may include other output device 1705 (or corresponding interface circuitry, as discussed above). Examples of the other output device 1705 may include an audio codec, a video codec, a printer, a wired or wireless transmitter for providing information to other devices, or an additional storage device.

Computing device 1700 may include other input device 1711 (or corresponding interface circuitry, as discussed above). Examples of the other input device 1711 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1700 may include a security interface device 1712. Security interface device 1712 may include any device that provides security measures for computing device 1700 such as intrusion detection, biometric validation, security encode or decode, access list management, malware detection, or spyware detection.

Computing device 1700, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-17. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes first and second metallization layers, and a transistor structure including a gate electrode between source and drain regions, the transistor structure between the first and second metallization layers, wherein a first of the source and drain regions is coupled to the first metallization layer, and a dielectric structure is between the second metallization layer and the first of the source and drain regions, the dielectric structure including a seam and opposing first and second sides, the first side in contact with the first of the source and drain regions, the seam on or intersecting the second side, opposite the first side.

In one or more second embodiments, further to the first embodiments, the first of the source and drain regions is coupled to the first metallization layer by a first metal structure in contact with the first of the source and drain regions and between the first of the source and drain regions and the first metallization layer, and a second of the source and drain regions is coupled to the second metallization layer by a second metal structure in contact with the second of the source and drain regions and between the second of the source and drain regions and the second metallization layer.

In one or more third embodiments, further to the first or second embodiments, a first sidewall or first widest edge of the dielectric structure is precisely vertically aligned with a second sidewall of the first metal structure.

In one or more fourth embodiments, further to the first through third embodiments, a third sidewall or third widest edge of the second metal structure is precisely vertically aligned with a fourth sidewall of a second dielectric material between the second of the source and drain regions and the first metallization layer.

In one or more fifth embodiments, further to the first through fourth embodiments, the gate electrode is coupled to the second metallization layer by a third metal structure in contact with the gate electrode and between the gate electrode and the second metallization layer.

In one or more sixth embodiments, further to the first through fifth embodiments, the third metal structure is between first and second dielectric layers, and the first and second dielectric layers are between the dielectric structure and the second metal structure.

In one or more seventh embodiments, further to the first through sixth embodiments, the first of the source and drain regions is coupled to the first metallization layer by a first metal structure in contact with the first of the source and drain regions and between the first metallization layer and the first of the source and drain regions, a second of the source and drain regions is coupled to the first metallization layer by a second metal structure in contact with the second of the source and drain regions and between the first metallization layer and the second of the source and drain regions, and the gate electrode is coupled to the second metallization layer by a third metal structure in contact with the gate electrode and between the second metallization layer and the gate electrode.

In one or more eighth embodiments, further to the first through seventh embodiments, the second side of the dielectric structure is in contact with the second metallization layer.

In one or more ninth embodiments, further to the first through eighth embodiments, the seam extends from the second side of the dielectric structure into the dielectric structure, toward a bulk of the dielectric structure.

In one or more tenth embodiments, an apparatus includes first and second metallization layers, and a transistor structure between the first and second metallization layers, the transistor structure including a gate electrode between source and drain regions, wherein a first of the source and drain regions is coupled to the first metallization layer, a second of the source and drain regions is coupled to the second metallization layer by a first metal structure in contact with the second of the source and drain regions, the gate electrode is coupled to a metal line in the second metallization layer by a second metal structure in contact with the gate electrode, a first dielectric structure is between and in contact with the metal line and the first of the source and drain regions, a second dielectric structure is between and in contact with the metal line and the second of the source and drain regions, and the first dielectric structure has a first composition different than a second composition of the second dielectric structure.

In one or more eleventh embodiments, further to the tenth embodiments, the first of the source and drain regions is coupled to the first metallization layer by a third metal structure, and a first sidewall or first widest edge of the first dielectric structure is precisely vertically aligned with a second sidewall of the third metal structure.

In one or more twelfth embodiments, further to the tenth or eleventh embodiments, the first dielectric structure includes a seam and opposing first and second sides, the first side is in contact with the first of the source and drain regions, and the seam is on or intersecting the second side, opposite the first side.

In one or more thirteenth embodiments, a method includes forming alternating first and second rows of first and second sacrificial materials on a first side of a substrate, wherein the substrate includes a first array of transistor structures coupled to a metallization network on a second side opposite the first side, and a second array of sacrificial structures is between and in contact with the first array and the first rows, replacing the first sacrificial material in the first rows with a dielectric material, removing the second rows of the second sacrificial material, exposing first portions of a first set of the transistor structures by etching between the first rows, forming first contacts on the first side to the first set of the transistor structures, removing the first rows of the dielectric material, and replacing the sacrificial structures with dielectric plugs and with second contacts on the first side to second portions of a second set of the transistor structures.

In one or more fourteenth embodiments, further to the thirteenth embodiments, the forming the alternating first and second rows includes directed self-assembly, and the first sacrificial material of the first rows and the second sacrificial material of the second rows include self-assembled monolayers of organic molecules.

In one or more fifteenth embodiments, further to the thirteenth or fourteenth embodiments, the dielectric material is a first dielectric material, and the replacing the sacrificial structures with the dielectric plugs includes forming a third array of voids by selectively removing the sacrificial structures, and conformally depositing a second dielectric material in the voids and over the substrate.

In one or more sixteenth embodiments, further to the thirteenth through fifteenth embodiments, the metallization network on the second side of the substrate is a first metallization network, and the method also includes forming a second metallization network on the first side, the second metallization network coupled to the first metallization network on the second side and to the first and second contacts.

In one or more seventeenth embodiments, further to the thirteenth through sixteenth embodiments, the method also includes forming first caps over the first contacts and second caps over the second contacts, wherein the forming the first caps includes depositing a third dielectric material over the first contacts, the forming the second caps over the second contacts includes depositing a fourth dielectric material of the second caps, the third dielectric material has an etch selectivity with the fourth dielectric material, and the forming the second metallization network includes a first selective etch of the third dielectric material and the first caps and a second selective etch of the fourth dielectric material and the second caps.

In one or more eighteenth embodiments, further to the thirteenth through seventeenth embodiments, the removing the second rows of the second sacrificial material exposes a fifth dielectric material between the sacrificial structures, the exposing the first portions of the first set of the transistor structures includes etching through the fifth dielectric material, the first array of transistor structures includes a plurality of gate electrodes between a plurality of semiconductor regions, the sacrificial structures are in contact with the semiconductor regions, and the exposed first portions are of the gate electrodes of the first set of the transistor structures.

In one or more nineteenth embodiments, further to the thirteenth through eighteenth embodiments, the etching between the first rows exposes a hole sidewall over a first of the gate electrodes and adjacent a first of the sacrificial structures, and the method also includes forming a dielectric layer on the exposed hole sidewall.

In one or more twentieth embodiments, further to the thirteenth through nineteenth embodiments, the method also includes forming the sacrificial structures under the transistor structures on the second side by opening a fourth array of holes in the substrate, depositing a metallic material into the holes, and forming a fifth array of semiconductor regions over the sacrificial structures.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
first and second metallization layers; and
a transistor structure comprising a gate electrode between source and drain regions, the transistor structure between the first and second metallization layers, wherein:
a first of the source and drain regions is coupled to the first metallization layer; and
a dielectric structure is between the second metallization layer and the first of the source and drain regions, the dielectric structure comprising a seam and opposing first and second sides, the first side in contact with the first of the source and drain regions, the seam on or intersecting the second side, opposite the first side.

2. The apparatus of claim 1, wherein the first of the source and drain regions is coupled to the first metallization layer by a first metal structure in contact with the first of the source and drain regions and between the first of the source and drain regions and the first metallization layer, and a second of the source and drain regions is coupled to the second metallization layer by a second metal structure in contact with the second of the source and drain regions and between the second of the source and drain regions and the second metallization layer.

3. The apparatus of claim 2, wherein a first sidewall or first widest edge of the dielectric structure is precisely vertically aligned with a second sidewall of the first metal structure.

4. The apparatus of claim 2, wherein a third sidewall or third widest edge of the second metal structure is precisely vertically aligned with a fourth sidewall of a second dielectric material between the second of the source and drain regions and the first metallization layer.

5. The apparatus of claim 2, wherein the gate electrode is coupled to the second metallization layer by a third metal structure in contact with the gate electrode and between the gate electrode and the second metallization layer.

6. The apparatus of claim 5, wherein the third metal structure is between first and second dielectric layers, and the first and second dielectric layers are between the dielectric structure and the second metal structure.

7. The apparatus of any one of claims 1-6, wherein the seam extends from the second side of the dielectric structure into the dielectric structure, toward a bulk of the dielectric structure.

8. A method, comprising:
forming alternating first and second rows of first and second sacrificial materials on a first side of a substrate, wherein the substrate comprises a first array of transistor structures coupled to a metallization network on a second side opposite the first side, and a second array of sacrificial structures is between and in contact with the first array and the first rows;
replacing the first sacrificial material in the first rows with a dielectric material;
removing the second rows of the second sacrificial material;
exposing first portions of a first set of the transistor structures by etching between the first rows;
forming first contacts on the first side to the first set of the transistor structures;
removing the first rows of the dielectric material; and
replacing the sacrificial structures with dielectric plugs and with second contacts on the first side to second portions of a second set of the transistor structures.

9. The method of claim 8, wherein the forming the alternating first and second rows comprises directed self-assembly, and the first sacrificial material of the first rows and the second sacrificial material of the second rows comprise self-assembled monolayers of organic molecules.

10. The method of either claim 8 or 9, wherein the dielectric material is a first dielectric material, and the replacing the sacrificial structures with the dielectric plugs comprises:
forming a third array of voids by selectively removing the sacrificial structures; and
conformally depositing a second dielectric material in the voids and over the substrate.

11. The method of any one of claims 8-10, wherein the metallization network on the second side of the substrate is a first metallization network, further comprising forming a second metallization network on the first side, the second metallization network coupled to the first metallization network on the second side and to the first and second contacts.

12. The method of claim 11, further comprising forming first caps over the first contacts and second caps over the second contacts, wherein:
the forming the first caps comprises depositing a third dielectric material over the first contacts;
the forming the second caps over the second contacts comprises depositing a fourth dielectric material of the second caps;
the third dielectric material has an etch selectivity with the fourth dielectric material; and
the forming the second metallization network comprises a first selective etch of the third dielectric material and the first caps and a second selective etch of the fourth dielectric material and the second caps.

13. The method of any one of claims 8-12, wherein:
the removing the second rows of the second sacrificial material exposes a fifth dielectric material between the sacrificial structures;
the exposing the first portions of the first set of the transistor structures comprises etching through the fifth dielectric material;
the first array of transistor structures comprises a plurality of gate electrodes between a plurality of semiconductor regions;
the sacrificial structures are in contact with the semiconductor regions; and
the exposed first portions are of the gate electrodes of the first set of the transistor structures.

14. The method of claim 13, wherein the etching between the first rows exposes a hole sidewall over a first of the gate electrodes and adjacent a first of the sacrificial structures, further comprising forming a dielectric layer on the exposed hole sidewall.

15. The method of any one of claims 8-14, further comprising forming the sacrificial structures under the transistor structures on the second side by opening a fourth array of holes in the substrate, depositing a metallic material into the holes, and forming a fifth array of semiconductor regions over the sacrificial structures.
